(19) Europäisches Patentamt
European Patent Office
Office européen des brevets

(11) **EP 1 501 146 A2**

(12) **EUROPEAN PATENT APPLICATION**

(43) Date of publication:
26.01.2005 Bulletin 2005/04

(51) Int Cl.⁷: **H01M 8/04**

(21) Application number: 04017146.4

(22) Date of filing: 20.07.2004

(84) Designated Contracting States:
AT BE BG CH CY CZ DE DK EE ES FI FR GB GR HU IE IT LI LU MC NL PL PT RO SE SI SK TR
Designated Extension States:
AL HR LT LV MK

(30) Priority: 24.07.2003 JP 2003279403
25.07.2003 JP 2003279831

(71) Applicant: MATSUSHITA ELECTRIC INDUSTRIAL CO., LTD.
Kadoma-shi, Osaka 571-8501 (JP)

(72) Inventors:
• Takebe, Yasuo
Uji-shi Kyoto 611-0002 (JP)
• Teranishi, Masatoshi
Settsu-shi Osaka 566-0043 (JP)
• Nakagawa, Takashi
Moriguchi-shi Osaka 570-0008 (JP)
• Uchida, Makoto
Hirakata-shi Osaka 573-1145 (JP)
• Segawa, Terutsugu
Neyagawa-shi Osaka 572-0055 (JP)

(74) Representative: Jung HML Pantentanwälte
Schraudolphstrasse 3
80799 München (DE)

(54) **Fuel cell system, fuel cell operation method, program, and recording medium**

(57) There have been insufficient highly reliable responses appropriate to the causes of power generation abnormalities in fuel cells that generate power by supplying an oxidizing agent containing oxygen to the cathode and by supplying a fuel gas containing hydrogen to the anode. In order to overcome this problem the invention provides for a fuel cell power generation system equipped with a means that includes AC signal generation block 503 and load 502 that varies the load current for fuel cell 501, which operates to generate power; voltage measurement block 504 that measures the voltage response to the load current variation; impedance measurement block 505 that computes the impedance of fuel cell 501, based on the results of the measurement of the voltage response; and fuel cell control block 506 that varies the operating conditions of fuel cell 501, by utilizing the impedance computation results.

[Fig. 1]

**Description**

[Technical Field]

The present invention relates to a fuel cell system, fuel cell operation method, program, and recording medium for the prevention of such problems as power generation abnormality in a polymer electrolyte fuel cell.

In the present specification the term "fuel cell" is to be understood as generic term if the context is not different if not the opposite is to be taken from the present specification. Thus "fuel cell" as generic term includes particularly arrangements in which a plurality of individual cells of fuel cell type cooperate, which is the case, for instance, in one fuel cell stack, a multiplicity of such stacks, fuel cell units or even fuel cell plants.

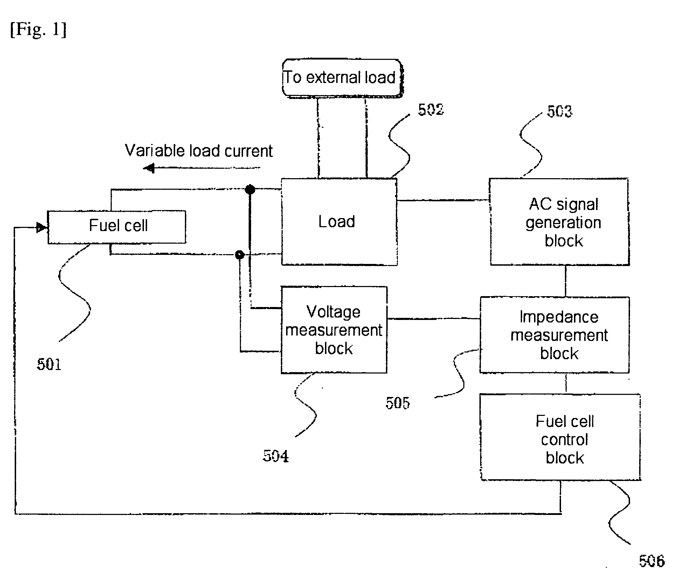

"Individual fuel cells" in the present specification in general are simply called "cells". The term "fuel cell stack" is used as well in the given context. For the term "fuel cell" the broader term "fuel cell power generation" or more simply "fuel cell system" is used (cf. reference number "1" in Fig. 1 of the drawings). Shorter one could use as well the term "fuel cell means". The term fuel "cell stack" sometimes is called simply "stacks" (reference signs 21, 22 ... 2n in Fig. 1 of the drawings) and the individual cells themselves have in Fig. 1 the reference number 31, 32, ... 3m. This wording is maintained in the description of the further embodiments.

[Background Art]

A fuel cell generates power by supplying to the cathode an oxidizing agent containing oxygen and by supplying to the anode a fuel gas containing hydrogen, and it is composed of a fuel cell comprised of a cathode-anode pair or a fuel cell stack in which multiple fuel cells are connected in series.

A power generation abnormality in a fuel cell generally is detected by monitoring the fuel cell voltage. However, this method is poor at determining the cause of the power generation abnormality.

To be more specific, it cannot be determined whether a fuel cell voltage drop occurred because gas diffusion inhibition increased diffusion resistance or because decreased electrode reactivity increased reaction resistance.

One technique for determining the cause of such a power generation abnormality is as follows: The AC impedance in the normal state is measured in advance at a specific frequency, after which alternating current with this specific frequency is impressed also during power generation, and the impedance in the power generation state is measured. Then the AC impedance in the normal state and the impedance in the power generation state are compared (for example, refer to Unexamined Patent Application Publication No. 2002-367650 (Patent Document 1)).

More concretely, as shown in Drawing 24, the block diagram of a conventional fuel cell power generation system 1, impedance measurement devices 71, 72,...7n are provided in multiple stacks 21, 22,...2n (also called fuel cell stacks or PEFC stacks), respectively. The AC voltages generated by impedance measurement devices 71, 72,... 7n are impressed in multiple stacks 21, 22,...2n, after which the impedances are measured.

The AC voltage is impressed at least at the frequencies 5 Hz and 40 Hz, and the diffusion resistance and reaction resistance are determined from the impedances at these frequencies.

Other prior art documents, in which the impedance of the fuel cell is measured directly for at least one frequency of an AC signal imposed are JP 62-222573 Document 2), DE 102 20 172 A1 (Document 3), DE 102 32 130 A 1 (Document 4) , US 2004/0091759 A1 (Document 5), and WO 2004/049490 A2 (Document 6). In Document 6 instead of the impedance (claim 17) a voltage can be measured directly (claim 16).

The fact that the average experts in the present technical field of monitoring a fuel cell with respect to the health of any component of the fuel cell is demonstrated best in the very recent 2003/0022032 A1 (Document 7) using a supplementary electrode in every cell. It is believed that the solution according to the invention overcomes a prejustice of the average expert of the art involved.

[Disclosure of the Invention]

[Problems That the Invention Is to Solve]

When an attempt is made to determine an abnormality from the fuel cell impedance, it first is necessary to measure the impedance with high precision.

In Document 1, for instance, in the conventional fuel cell power generation system 1, the inverter 6, that is the load circuit, is connected in parallel with stacks 21, 22,...2n to be measured. As a result, unless the impedance of inverter 6 is subtracted, the impedance of each stack 21, 22,...2n cannot be measured.

Inverter 6 ordinarily performs a switching operation, and its load impedance varies constantly. As a result, it is difficult to precisely determine the impedance of each stack 21, 22,...2n, by subtracting the impedance of inverter 6.

Furthermore, when an attempt is made to operate a fuel cell in the optimal state, it is necessary to determine the power generation state of each cell 31, 32,...3m (also called fuel cell or PEFC cell).

However, in the aforementioned conventional fuel cell power generation system 1, although the impedance of the entire stack can be measured, it is difficult to infer from it information regarding each cell 31, 32,...3m.

If the impedances of cells 31, 32,...3m were identical, it would be possible to compute the impedance of each cell 31, 32,...3m from the impedance of the entire stack. In fact, however, each cell forming stacks 21, 22,...2n is in a different state, so the impedance differs in each cell 31, 32,...3m. As a result, the impedance of the entire stack combines the impedances of cells 31, 32,...3m, so it is almost impossible to derive the impedances of cells 31, 32,...3m from this value.

When there is an abnormality that degrades the power generation voltages of stacks 21, 22,...2n, some of their cells 31, 32,...3m first exhibit an abnormality.

Therefore, the inventor(s) of the present invention believe it to be preferable to determine information regarding each cell 31, 32,...3m, to detect and appropriately inhibit an abnormality at the early stage of deterioration.

In short, to obtain information regarding the cause of an abnormality, it is important to identify the location of the cell 31, 32,...3m that exhibits the abnormality, and simply to measure the impedances of stacks 21, 22,...2n is an inadequate response to an abnormality.

Moreover, it naturally becomes possible to determined information regarding each cell 31, 32,...3m, by providing an impedance measurement device for each cell 31, 32,...3m. However, an impedance measurement device is required for each cell 31, 32,...3m, which increases the cost substantially, so this is impractical.

Ultimately, the problem has been the lack of an adequate response with high reliability, that is appropriate to the cause of the power generation abnormality in a fuel cell.

The problems in the devices according to Documents 2 to 6 are similar.

The present invention takes the aforementioned conventional problems into consideration, and it aims at providing a fuel cell system, fuel cell operation method, program, and recording medium that enable a more highly reliable response that is appropriate to the cause of the power generation abnormality of a fuel cell

[Object of the Invention and Means of Solving the Problems]

An object of the invention is to overcome the above mentioned problems of the prior art with a more highly reliable response than before without undergoing the complications of monitoring each individual cell separately.

None of the publications of prior art discloses to vary the input load and to monitor the resulting voltage drop across the fuel cell means and to calculate the critical impedance only indirectly from the received voltage characteristic independent of the varied load.

The claims 2 to 42 concern preferred embodiments of the fuel cell. Notwithstanding the fact that all those subclaims are referred back only on one preceding claim each it is evident, that features of such subclaims which are suited to be combined, are considered to be protected in combination as well.

Claim 43 to claim 45 concern further realisations of the invention as method, program and recording medium of the program.

[Effects of the Invention]

The present invention has the advantage of enabling a more highly reliable response that is appropriate to the cause of a power generation abnormality in a fuel cell.

[Best Modes for Carrying Out the Invention]

Next, the embodiments of the present invention will be explained with reference to the drawings.

[Brief Explanation of the Drawings]

[Fig. 1]
Block diagram of the fuel cell power generation system of Embodiment 1 of the present invention.
[Fig. 2]
Diagram plotting the impedance measured by sweeping the frequencies of Embodiment 1 of the present invention.
[Fig. 3]
Diagram of the equivalent circuit that represents the impedance of the cell of Embodiment 1 of the present invention.
[Fig. 4]

Diagram showing the relationship between the S/N ratio and the ratio of the AC current amplitude to the DC current, in Embodiment 1 of the present invention.

[Fig. 5]

Diagram of the Cole-Cole plot of Embodiment 1 of the present invention.

[Fig. 6]

Diagram plotting the equivalent circuit component sets measured by varying the air utilization rate, of Embodiment 1 of the present invention.

[Fig. 7]

Flowchart for explaining the system control of Embodiment 1 of the present invention (part 1).

[Fig. 8]

Flowchart for explaining the system control of Embodiment 1 of the present invention (part 2).

[Fig. 9]

Flowchart for explaining the system control of Embodiment 1 of the present invention (part 3).

[Fig. 10]

Diagram for showing the area of $(C_3, R_3)$ in the system control of Embodiment 1 of the present invention.

[Fig. 11]

Diagram for showing the area of $(C_2, R_2)$ in the system control of Embodiment 1 of the present invention.

[Fig. 12]

Diagram for showing the area of $(C_1, R_1)$ in the system control of Embodiment 1 of the present invention.

[Fig. 13]

Block diagram of the fuel cell power generation system of Embodiment 2 of the present invention.

[Fig. 14]

Block diagram of the fuel cell power generation system of Embodiment 3 of the present invention.

[Fig. 15]

Block diagram of the fuel cell power generation system of Embodiment 4 of the present invention.

[Fig. 16]

Block diagram of automatic connection device housed in the cell of Embodiment 4 of the present invention.

[Fig. 17]

Diagram of the equivalent circuit that represents the impedance of the cell of Embodiment 4 of the present invention.

[Fig. 18]

Diagram of the Cole-Cole plot of Embodiment 4 of the present invention.

[Fig. 19]

Flowchart for explaining the system control of Embodiment 4 of the present invention (part 1).

[Fig. 20]

Flowchart for explaining the system control of Embodiment 4 of the present invention (part 2).

[Fig. 21]

Flowchart for explaining the system control of Embodiment 4 of the present invention (part 3).

[Fig. 22]

Diagram showing the change over time in the cell voltage in Embodiment 1 and the comparative example of the present invention.

[Fig. 23]

Diagram showing the change over time in voltage in Embodiments 2-6 of the present invention.

[Fig. 24]

Block diagram of a conventional fuel cell power generation system 1.

## Embodiment 1

First, the configuration of the fuel cell power generation system of the present embodiment will be explained with reference mainly to Fig. 1, the block diagram of the fuel cell power generation system of Embodiment 1 of the present invention.

The fuel cell power generation system of the present embodiment is a fuel cell power generation system that generates power by supplying an oxidizing agent containing oxygen to the cathode and by supplying a fuel gas containing hydrogen to the anode. Moreover, fuel cell power generation system of the present embodiment has AC signal generation block 503 that varies the load current of fuel cell 501 and voltage measurement block 504 that measures the voltage response of fuel cell 501. Impedance measurement block 505 measures the impedance of fuel cell 501, from the phase difference between the voltage response and the load current. The operating conditions are varied in accordance with the impedance value.

Furthermore, load 502, which is equivalent to an orthogonal conversion inverter for converting DC to AC (ditto hereinafter), is connected in series with the fuel cell 501 to be measured.

The fuel cell power generation system of the present embodiment can easily and precisely measure the impedance in the fuel cell power generation system.

Next, the operation of the fuel cell power generation system of the present embodiment will be explained. Furthermore, while the operation of the fuel cell power generation system of the present embodiment is being explained, one embodiment of the fuel cell operation method of the present invention also will be explained. (The same applies to the other embodiments.)

Fuel cell 501 is connected to load 502. The current that flows through load 502 is controlled by the signal from AC signal generation block 503, and the load current varied at the AC signal frequency flows in fuel cell 501.

Changes in the voltage of fuel cell 501 are monitored by voltage measurement block 504, and impedance measurement block 505 computes the impedance from the phase difference relative to the AC signal.

As described in detail hereinafter, fuel cell control block 506 controls by varying the operating conditions for fuel cell 501, in accordance with the impedance value.

Of course, in the fuel cell power generation system of the present embodiment, the representative fuel cell is composed of one fuel cell. However, after connecting a fuel cell stack composed of multiple stacked fuel cells, instead of a fuel cell, it also is possible to measure the impedance of the entire fuel cell stack.

Furthermore, the means that includes load 502 and AC signal generation block 503 corresponds to the load current variation means of the present invention. Voltage measurement block 504 corresponds to the measurement means of the present invention. Impedance measurement block 505 corresponds to the computation means of the present invention. Fuel cell control block 506 corresponds to the fuel cell control means of the present invention. The fuel cell power generation system of the present embodiment corresponds to the fuel cell system of the present invention.

This completes the explanation of the configuration and operation of the fuel cell system of the present embodiment. Next, the principles of impedance computation and operating condition control in the same fuel cell system will be explained in detail. The fuel cells that make up a fuel cell stack are composed of a hydrogen ion-conductive electrolyte membrane and electrodes disposed on both sides thereof (i.e., the so-called polymer electrolyte type).

A fuel cell is configured by providing a pair of separator plates having a gas flow channel that supplies and discharges fuel gas on one side of this electrode and having a gas flow channel that supplies and discharges oxygen-containing gas on the other side. Furthermore, the electrode that supplies fuel gas is the anode, and the electrode that supplies oxygen-containing gas is the cathode.

A fuel cell stack is formed by stacking several tens to several hundreds of this fuel cell.

The fuel cell impedance consists of the impedance of the anode, the impedance of the cathode, the electrolyte membrane's impedance, and contact resistance of each component.

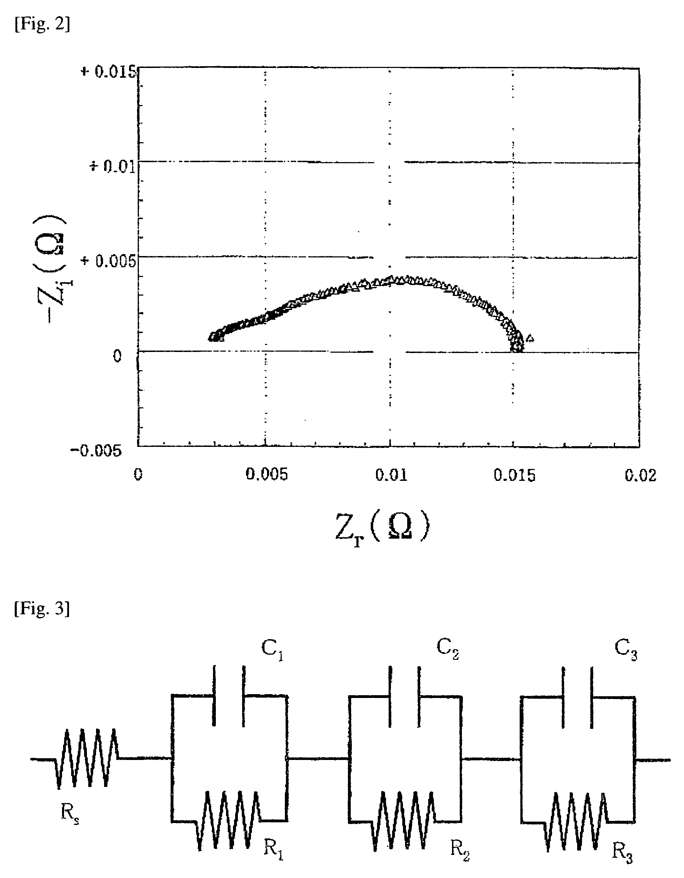

As explained in detail hereinafter, the imaginary part (with reversed sign) is plotted against the real part of the impedance of a typical fuel cell, in Fig. 2, the diagram in which are plotted the impedances measured by sweeping the frequencies of Embodiment 1 of the present invention.

Furthermore, the present inventors discovered that, as the equivalent circuit representing the behavior of this impedance, the equivalent circuit shown in Fig. 3, which is an diagram of the equivalent circuit representing the cell impedance of Embodiment 1 of the present invention, has very high precision.

Next, the method used to measure the impedance characteristics will be explained.

An AC current, which has frequency f and a small amplitude of at most 10% of the current amplitude of the DC current retrieved from the fuel cell, is retrieved after superimposing it on the DC current. Here, the load current variation range is 0-200% of the rated output of the fuel cell.

The impedance is computed from the amplitude and phase of the AC component of the cell current and from the AC component of the cell voltage, which are measured at that time.

Normally, the larger the amplitude of the impressed AC current, the higher the S/N ratio (signal/noise ratio).

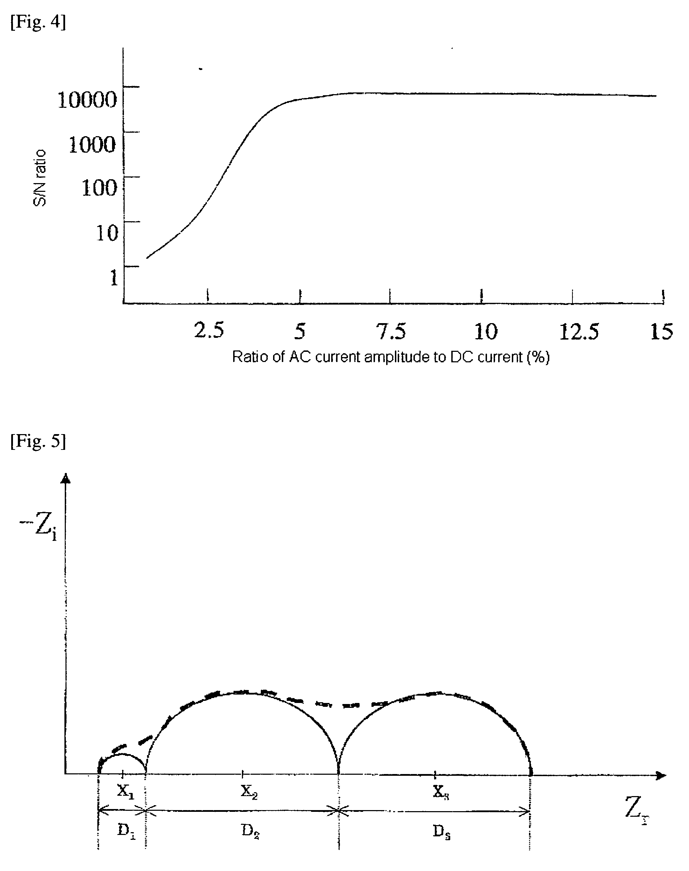

As shown in Fig. 4, which shows the relationship between the S/N ratio and the ratio of the AC current amplitude to the DC current in Embodiment 1 of the present invention, the S/N ratio saturates when the ratio of the AC current amplitude to the DC current exceeds 5%, and even if the amplitude increases further, the S/N ratio hardly increases.

On the other hand, in the case of the fuel cell, the current flowing through the cell is associated with the charge transfer resulting from the chemical reaction, so when the AC current amplitude is increased, the reaction volume relative to the supply gas volume (i.e., the gas utilization rate) varies.

Normally, if the impressed AC current has an amplitude of at most 10% of the DC current, there is little variation in the gas utilization rate, and measurement is unaffected. However, if the impressed AC current has an amplitude exceeding 10% of the DC current, the effect of variation in the gas utilization rate is not negligible, and a measurement error occurs readily.

For these reasons, the amplitude of the impressed AC current preferably is about 5-10% of the DC current.

Letting the complex impedance of the equivalent circuit be Z, its real part be $Z_r$, and the imaginary part with the changed sign be $Z_i$, it is described as

$$[\text{Relationship 18}] \qquad Z = Z_r - jZ_i$$

where the imaginary unit is j (ditto hereinafter).

Also, letting the cell voltage AC component during measurement be the complex number E, its real part be $E_r$, its imaginary part with the changed sign be $E_i$, the AC component of the cell current be imaginary number I, its real part be $I_r$, and its imaginary part with the changed sign be $I_i$, it is described as

$$[\text{Relationships 19}]$$

$$E = E_r - jE_i \ , \ I = I_r - jI_i \ ,$$

$$Z = E/I = (E_r - jE_i) / (I_r - jI_i)$$

Consequently, the complex impedance Z at that time can be computed from E and I measured after the retrieval of the AC current with frequency f.

Furthermore, frequency f of the AC current to be retrieved is swept from about 0.1 Hz to about 1000 Hz, and the complex impedance Z at each frequency is computed similarly.

Also, it is preferable to sweep frequency f within the range from 0.01 Hz to 1 MHz. Next, these are plotted on a complex plane, with its real part $Z_r$ as the horizontal axis and its negative complex part $Z_i$ as the vertical axis, to create the Cole-Cole plot shown in Fig. 5, which is a diagram of the Cole-Cole plot of Embodiment 1 of the present invention.

The Cole-Cole plot when the equivalent circuit is a circuit with a pair of resistors and capacitors connected in parallel becomes a semicircle with a fixed radius and with its center on the horizontal axis (in accordance with the so-called Cole-Cole circular arc law).

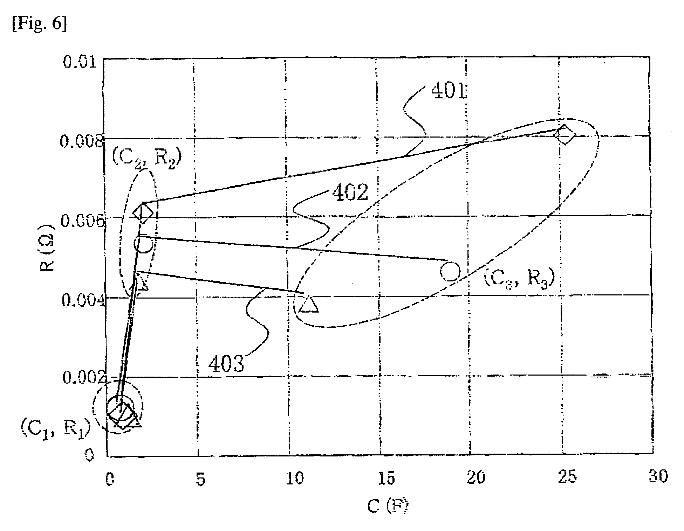

The Cole-Cole plot (as in Fig. 6) for the equivalent circuit having resistor (resistance) and capacitor (capacitance) sets $(R_1, C_1)$, $(R_2, C_2)$, and $(R_3, C_3)$ as well as the resistor (resistance) $R_3$ has a shape that superimposes and combines three semicircles. In Fig. 5, the three semicircles are shown as solid lines, and the shape that combines these superimposed semicircles is shown as a dashed line.

The radii and center coordinates of the semicircles are determined one by one, from the low-frequency side, to conform to the drawn shapes. For the 1st, 2nd, and 3rd semicircles, the center coordinates are set to $X_1$, $X_2$, and $X_3$, respectively, and the diameters are set to $D_1$, $D_2$, and $D_3$, respectively.

Letting the frequencies corresponding to the point on each semicircle at which the imaginary part is maximum be $f_1$, $f_2$, and $f_3$, respectively,

$$[\text{Relationships 20}]$$

$$C_1 = \frac{1}{2\pi f_1 R_1} = \frac{1}{2\pi f_1 D_1} \ , \ C_2 = \frac{1}{2\pi f_2 R_2} = \frac{1}{2\pi f_2 D_2} \ , \ C_3 = \frac{1}{2\pi f_3 R_3} = \frac{1}{2\pi f_3 D_3} \ ,$$

$$, \ R_{[S]} = X_1 - D_1/2, \ R_1 = D_1, \ R_2 = D_2, \ R_3 = D_3$$

Thus, it is possible to compute the values of the components $(C_1, R_1)$, $(C_2, R_2)$, and $(C_3, R_3)$ of the equivalent circuit, that are fitted to the Cole-Cole plot.

The correlations between the sets of C and R in the equivalent circuit are shown in Fig. 6, which is a diagram in which are plotted the sets of components of the equivalent circuit, following measurements obtained after varying the air utilization rate of Embodiment 1 of the present invention.

In Fig. 6, the C values are plotted in the horizontal axis and the R values are plotted in the vertical axis, with $(C_1, R_1)$, $(C_2, R_2)$, and $(C_3, R_3)$ as the respective sets. The correlation between C and R in the equivalent circuit was investigated by varying the operating conditions of the fuel cell.

As is readily evident in Fig. 6, broken line 401 connects $(C_1, R_1)$, $(C_2, R_2)$, and $(C_3, R_3)$ for the case of the 60% air utilization rate (i.e., oxygen utilization rate), broken line 402 connects $(C_1, R_1)$, $(C2, R2)$, and $(C_3, R_3)$ for the

case of the 40% air utilization rate, and broken line 403 connects $(C_1, R_1)$, $(C_2, R_2)$, and $(C_3, R_3)$ for the case of a 20% air utilization rate.

The approximate variation ranges of $(C_1, R_1)$, $(C_2, R_2)$, and $(C_3, R_3)$ are enclosed by dashed lines.

When the utilization rate of air, a gas containing oxygen, was varied, mainly $C_3$ and $R_3$ varied in this manner.

When the concentration of hydrogen in the fuel gas was varied, mainly $C_1$ and $R_1$ varied.

Also, when the fuel cell concentration was varied, mainly $C_2$ and $R_2$ varied. From this, it was determined that, in the equivalent circuit of Fig. 3, $C_1$ and $R_1$ are equivalent to the reactive impedance of the anode, $C_2$ and $R_2$ are equivalent to the reactive impedance of the cathode, and $C_3$ and $R_3$ are equivalent to the diffusion impedance of the cathode.

In this way, the impedance of each fuel cell during normal operation is measured in advance, and the values of the components of the equivalent circuit during normal operation are stored.

Then, by comparing with the stored normal component values the equivalent circuit's component values that were determined by measuring the impedance as needed during operation, it becomes possible to determine the fuel state and provide optimal system control during an abnormality.

Next, such system control will be explained in further detail, with reference mainly to Fig. 7, part 1 of the flowchart for explaining the system control of Embodiment 1 of the present invention; Fig. 8, part 2 of the flowchart for explaining the system control of Embodiment 1 of the present invention; and Fig. 9, part 3 of the flowchart for explaining the system control of Embodiment 1 of the present invention.

Steps 1-3: After power generation starts, the impedance is measured as needed. The values of the components of the equivalent circuit are determined from the measured impedances.

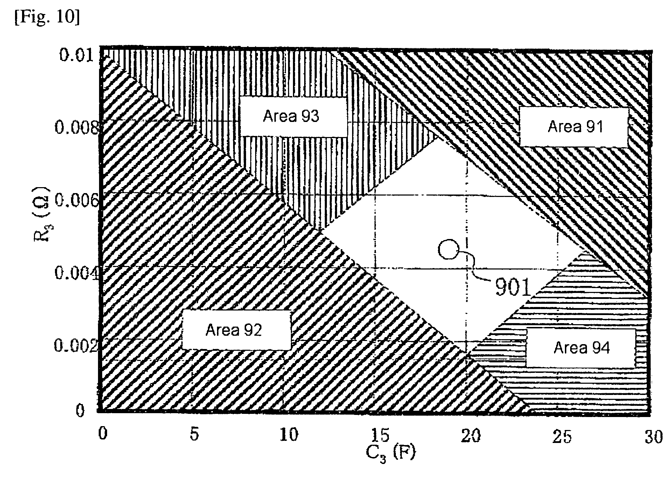

Steps 4-8: Determined next is the area in which equivalent circuit set $(C_3, R_3)$ lies in Fig. 10, the diagram for showing the area of $(C_3, R_3)$ in the system control of Embodiment 1 of the present invention.

As aforementioned, $(C_3, R_3)$ is the component based on the diffusion impedance of the cathode.

The initial value 901 of $(C_3, R_3)$ in Fig. 10 corresponds to the normal value of $(C_3, R_3)$. Furthermore, area 91 is the region defined by

$$[\text{Relationship 21}] \qquad -0.00041 C_3 + 0.015 \leq R_3$$

area 92 is the region defined by

$$[\text{Relationship 22}] \qquad R_3 \leq -0.00041 C_3 + 0.098$$

area 93 is the region defined by

[Relationships 23]

$$\begin{cases} C_3 \leq 2500 R_3 - 0.5 \\ -0.00041 C_3 + 0.0098 \leq R_3 \leq -0.00041 C_3 + 0.015 \end{cases}$$

and area 94 is the region defined by

[Relationships 24]

$$\begin{cases} 2500 R_3 + 16 \leq C_3 \\ -0.00041 C_3 + 0.0098 \leq R_3 \leq -0.00041 C_3 + 0.015 \end{cases}$$

When $R_3$ increases and $(C_3, R_3)$ moves into area 91, it is possible to determine that the gas diffusibility decreased as the result of wetting progress, so the air utilization rate $U_o$ is decreased for a given period to eliminate the wetting, and $R_3$ is decreased. The number iterations of the operation that reduces the air gas utilization $U_o$ for a given period is counted.

When this operation must be repeated numerous times and the count exceeds the predetermined value, it can be inferred that the electrode material itself deteriorated and readily became wet, so an alarm is output and operation continues in the state with a decreased air utilization rate $U_o$. The alarm can be used to suggest maintenance and to identify the cause of the problem during maintenance.

Steps 9-10: When $R_3$ decreases and $(C_3, R_3)$ enters area 92, it can be inferred that drying occurred, so, by increasing the air utilization ratio $U_o$, drying is controlled and $R_3$ is increased.

Steps 11-12: Even after $C_3$ decreases and $(C_3, R_3)$ enters area 93, it still can be considered wetting progress, but it is believed to be attributable to decreased fuel cell temperature. Consequently, by decreasing the amount of cooling water to increase the fuel cell temperature, the wetting is eliminated and $C_3$ is increased.

Steps 13-14: Conversely, after $C_3$ increases and $(C_3, R_3)$ enters area 94, by increasing the amount of cooling water to reduce the cell temperature, drying is controlled and $C_3$ is decreased.

The concrete categorization of areas 91, 92, 93, and 94 was performed empirically. However, stable operation can be maintained by following this flow. (Ditto hereinafter.)

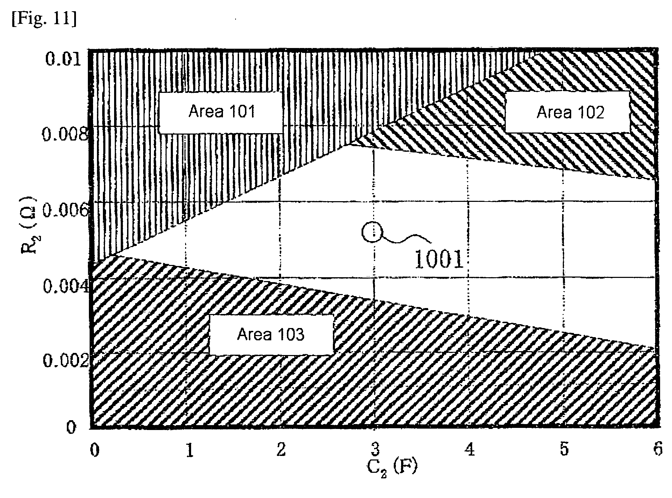

Next, Fig. 11 is used to determine the area in which $(C_2, R_2)$ lies in Fig. 11, the diagram that shows the areas of $(C_2, R_2)$ in the system control of Embodiment 1 of the present invention.

As aforementioned, $(C_2, R_2)$ is the component based on the reactive impedance of the cathode.

The initial value 1001 of $(C_2, R_2)$ in Fig. 11 corresponds to the normal value of $(C_2, R_2)$.

Furthermore, area 101 is the region defined by

$$[\text{Relationship 25}] \qquad C_2 \leq 1000R_2 - 5$$

area 102 is the region defined by

$$[\text{Relationships 26}]$$

$$\begin{cases} -0.0005C_2 + 0.0093 \leq R_2 \\ 1000R_2 - 5 \leq C_2 \end{cases}$$

and area 103 is the region defined by

$$[\text{Relationships 27}]$$

$$\begin{cases} R_2 \leq -0.0005C_2 + 0.005 \\ 1000R_2 - 5 \leq C_2 \end{cases}$$

Steps 15-19: When $C_2$ decreases and $(C_2, R_2)$ enters area 101, it is believed that the reactivity of the cathode catalyst decreased and the apparent electrode surface area decreased, so a recovery operation is performed to increase $C_2$.

In the recovery operation, the cathode voltage is decreased (i.e., the fuel cell voltage is decreased) either by flowing the load current after shutting off the air while flowing the fuel gas or by flowing, instead of air, a gas with an oxygen partial pressure lower than that of air, for example.

Such a recovery operation enables the restoration of a cathode catalyst with reactivity decreased by the adhesion of contaminants or the progress of oxidation.

Then, if this recovery operation must be performed because the reactivity again decreased shortly after the previous recovery operation, it implies considerable deterioration of the catalyst itself, so an alarm is output and operation is stopped.

Steps 20-21: When $R_2$ increases and $(C_2, R_2)$ enters area 102, it can be inferred that the catalyst dried and the reactivity decreased, so air humidification is increased to decrease $R_2$.

Steps 22-23: Conversely, when $R_2$ decreases and $(C_2, R_2)$ enters area 103, it is possible to determine that catalyst wetting is excessive, so air humidification is decreased to increase $R_2$.

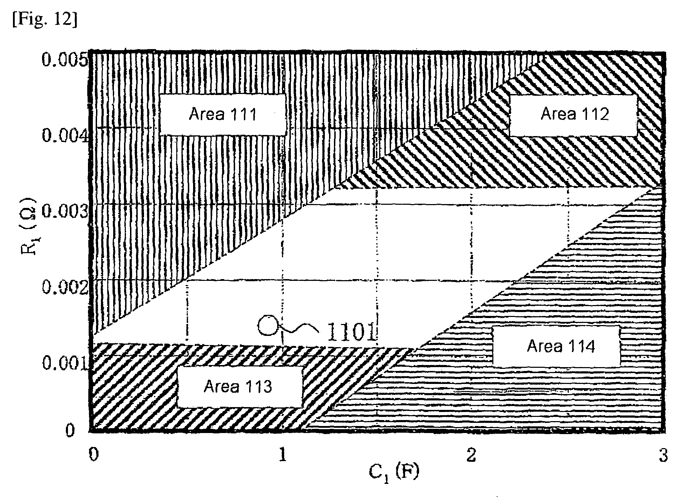

Next, Fig. 12 is used to determine the area in which $(C_1, R_1)$ lies in Fig. 12, the diagram that shows the areas

of $(C_1, R_1)$ in the system control of Embodiment 1 of the present invention.

As aforementioned, $(C_1, R_1)$ is the component based on the reactive impedance of the anode.

The initial value 1101 of $(C_1, R_1)$ in Fig. 12 corresponds to the normal value of $(C_1, R_1)$.

Furthermore, area 111 is the region defined by

$$[\text{Relationship 28}]\ C_1 \le 625R_1 - 0.75$$

area 112 is the region defined by

$$[\text{Relationships 29}]$$

$$\begin{cases} 0.0032 \le R_1 \\ 625R_1 - 0.75 \le C_1 \le 625R_1 + 1.1 \end{cases}$$

area 113 is the region defined by

$$[\text{Relationships 30}]$$

$$\begin{cases} R_1 \le 0.0011 \\ 625R_1 - 0.75 \le C_1 \le 625R_1 + 1.1 \end{cases}$$

and area 114 is the region defined by

$$[\text{Relationship 31}]\ 625R_1 + 1.1 \le C_1$$

Steps 24-28: When $C_1$ decreases and $(C_1, R_1)$ enters area 111, it is believed that the anode catalyst was poisoned and reactivity decreased, and that the apparent electrode surface area decreased, so the amount of air bleeding is increased in an attempt to increase $C_1$.

Air bleeding adds a small amount of air to the fuel gas and, on the catalyst surface, oxidizes and eliminates the carbon monoxide that poisons the catalyst.

If $(C_1, R_1)$ remains in area 111 even after the amount air bleeding is increased, anode catalyst deterioration is considerable, so an alarm is output and operation is stopped. Steps 29-30: When $R_1$ increases and $(C_1, R_1)$ lies in area 112, it can be inferred that the anode catalyst dried as the result of excessive fuel gas, so the fuel utilization rate $U_f$ is decreased and operation is performed to decrease $R_1$.

Steps 31-32: Conversely, when $R_1$ decreases and $(C_1, R_1)$ lies in area 113, the fuel utilization rate $U_f$ is increased to increase $R_1$.

Steps 33-34: When $C_1$ increases and $(C_1, R_1)$ lies in area 114, it is possible to determine that the amount of air bleeding is excessive, so the amount of air bleeding is decreased to decrease $C_1$.

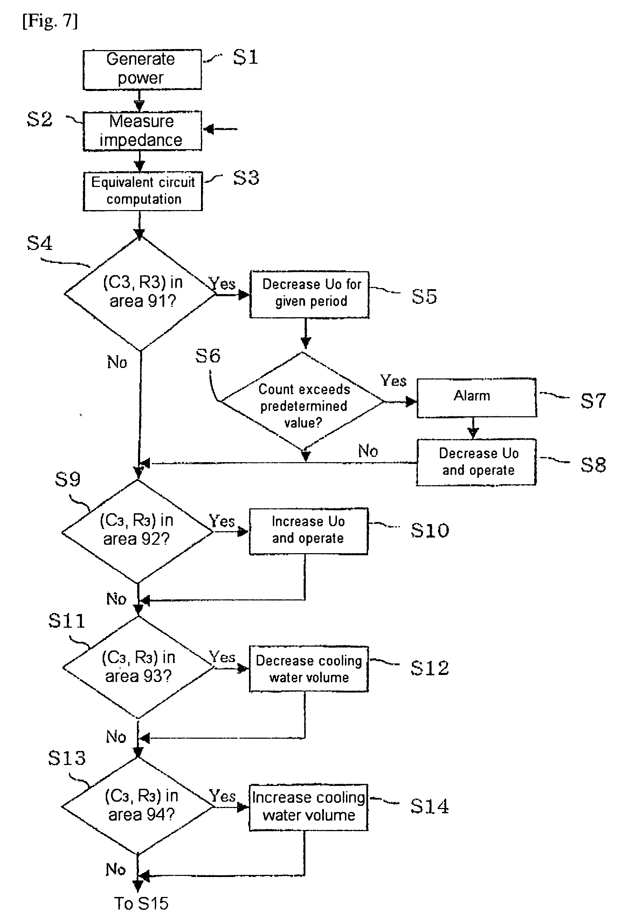

After a series of operations is performed in accordance with such a flow, the flow returns to the impedance measurement (i.e., step 2) of Fig. 7, and the same operations are repeated.

As aforementioned, concrete categorization such as that mentioned previously is performed empirically based on the initial value. Consequently, after the initial value is changed by varying the shape and configuration of the fuel cell, it is preferable to shift the area classification, also, based on this value.

Embodiment 2

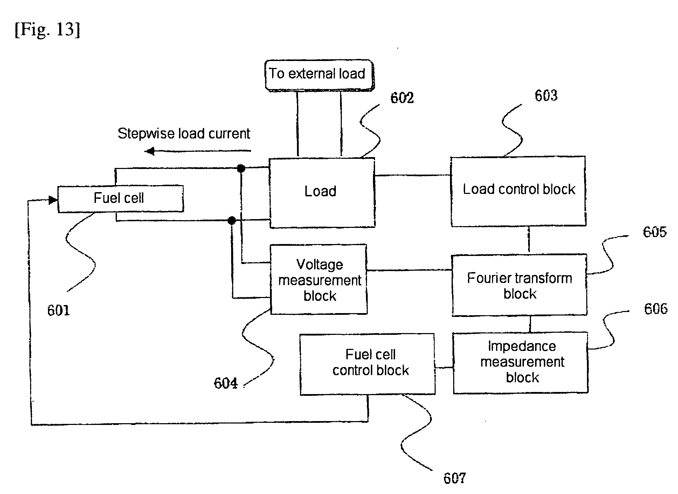

First, the configuration of the fuel cell power generation system of the present embodiment will be explained with reference mainly to Fig. 13, the block diagram of the fuel cell power generation system of Embodiment 2 of the present invention.

The configuration of the fuel cell power generation system in the present embodiment resembles the configuration of the fuel cell power generation system in aforementioned Embodiment 1, so the following description will concern mainly the differences between the two. (This also applies to Embodiment 3.)

The fuel cell power generation system of the present embodiment is a fuel cell power generation system that generates power by supplying an oxidizing agent containing oxygen to the cathode, and by supplying a fuel gas containing hydrogen to the anode. The fuel cell power generation system of the present embodiment has a load control block 603 that varies stepwise the load current of fuel cell 601 and has a voltage measurement block 604 that measures the transient voltage response of fuel cell 601. The system digitizes and subjects to Fourier transformation the time from load current variation and the voltage at that time. Then impedance measurement block 606 measures the impedance of fuel cell 601, and the operating conditions are varied in accordance with the impedance.

The fuel cell power generation system of the present embodiment can rapidly measure the impedance at all frequencies.

Next, the operation of the fuel cell power generation system of the present embodiment will be explained.

The operation of the fuel cell power generation system in the present embodiment resembles the operation of the aforementioned fuel cell power generation system in Embodiment 1, so the following description will concern mainly the differences between the two. (This also applies to Embodiment 3.)

Fuel cell 601 is connected to load 602, and load 602 is controlled by load control block 603. The stepped load current flows in fuel cell 601. Here, the load current variation range is set to 0-200% of the rated output of the fuel cell, and the stepped current variation is set to at least 10%.

Voltage measurement block 604 monitors changes in the voltage of the fuel cell during load current variation. The time from load variation and the voltage at that time are digitized, after which, as described hereinafter, Fourier transform block 605 subjects them to Fourier transformation.

After these are converted to the voltage response for the frequency, impedance measurement block 606 computes the impedance, after which fuel cell control block 607 controls to vary the operating conditions of fuel cell 601.

Of course, the load current may be varied intentionally for impedance measurement. However, this may be combined with varying the load current when switching the system ON/OFF or when increasing/decreasing the power generation capacity.

Next, the operation of Fourier transform block 605 will be explained in further detail. Letting the time function of stepwise-varied load current $I_a$ be $I_{step}$ (t) and letting the time function of the cell voltage at that time be $E_{step}$ (t), where t is the time, the frequency functions after the Fourier transformation of $I_{step}$ (t) and $E_{step}$ (t) are, respectively, as follows, where f is the frequency:

[Relationships 32]

$$FI_{step}(f) = \int_{-\infty}^{\infty} I_{step}(t)e^{-2\pi fjt}\,dt,$$

$$FE_{step}(f) = \int_{-\infty}^{\infty} E_{step}(t)e^{-2\pi fjt}\,dt,$$

Consequently, impedance $Z_{step}$ (f) becomes

[Relationship 33]    $Z_{step}$ (f) = $FE_{step}$ (f) / $FI_{step}$ (f)

In this manner, Fourier transform block 605 computes frequency functions $FI_{step}$ (f) and $FE_{step}$ (f) from time functions $I_{step}$ (t) and $E_{step}$ (t).

Of course, Fourier transform block 605 is composed of a digital computer, etc., so by dividing time functions $I_{step}$ (t) and $E_{step}$ (t) into a finite number and digitally computing, a finite number of $FI_{step}$ (f) and $FE_{step}$ (f) are determined, after which a finite number of impedances $Z_{step}$ (f) are computed.

Furthermore, the means that includes load 602 and load control block 603 corresponds to the load current variation means of the present invention; voltage measurement block 604 corresponds to the measurement means of the present invention; impedance measurement block 606 corresponds to the computation means of the present invention; fuel cell control block 607 corresponds to the fuel cell control means of the present invention; and the fuel cell power generation system of the present embodiment corresponds to the fuel cell system of the present invention.

Embodiment 3

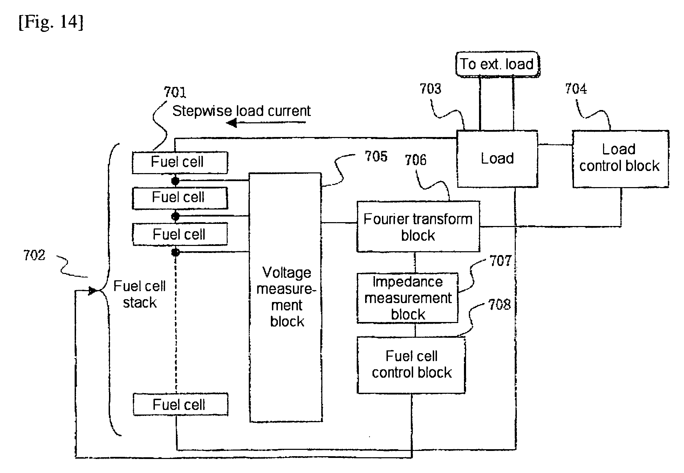

First, the configuration of the fuel cell power generation system of the present embodiment will be explained with reference mainly to Fig. 14, the block diagram of the fuel cell power generation system of Embodiment 3 of the present invention.

The fuel cell power generation system of the present embodiment is a system having fuel cell stack 702, in which are connected in series multiple fuel cells 701 that generate power by supplying to the cathode an oxidizing agent containing oxygen, and by supplying to the anode a fuel gas containing hydrogen.

The fuel cell power generation system of the present embodiment is a system having load control block 704 that varies the load 703 common to each fuel cell 701 and voltage measurement block 705 that can measure the voltage of each fuel cell 701. Impedance measurement block 707 measures the impedance of each fuel cell 701, and the operating conditions are varied in accordance with the impedance.

The fuel cell power generation system of the present embodiment can measure the impedance of each fuel cell 701 making up fuel cell stack 702.

Next, the operation of the fuel cell power generation system of the present embodiment will be explained.

Fuel cell stack 702, which is composed of stacked fuel cells 701, is connected to load 703. Load 703 is controlled by load control block 704, and a stepped load current flows in fuel cell stack 702.

The electrodes of each fuel cell 701 are connected to voltage measurement block 705. Voltage measurement block 705 monitors changes in the voltage of each fuel cell 701 during load current variation. It digitizes the time from load variation and the voltage at that time, which are subjected to Fourier transformation by Fourier transform block 706.

After these are converted to the voltage response for the frequency, impedance measurement block 707 computes the impedance. Then fuel cell control block 708 controls to vary the operating conditions of each fuel cell 701, in accordance with the impedance.

Of course, the load current may be varied intentionally for impedance measurement. However, this may be combined with varying the load current when switching the system ON/OFF or when increasing/decreasing the power generation capacity.

Furthermore, the means that includes load 703 and load control block 704 corresponds to the load current variation means of the present invention; voltage measurement block 705 corresponds to the measurement means of the present invention; impedance measurement block 707 corresponds to the computation means of the present invention; fuel cell control block 708 corresponds to the fuel cell control means of the present invention; and the fuel cell power generation system of the present embodiment corresponds to the fuel cell system of the present invention.

Embodiment 4

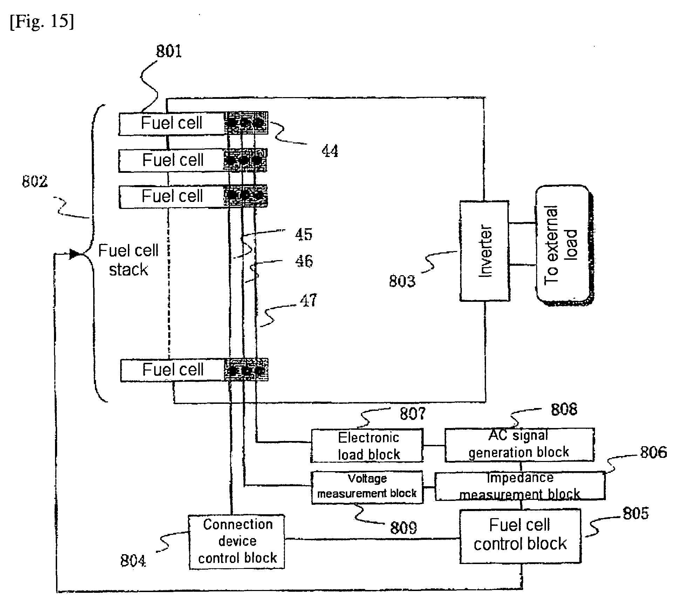

First, the configuration of the fuel cell power generation system of the present embodiment will be explained with reference mainly to Fig. 15, the block diagram of the fuel cell power generation system of Embodiment 4 of the present invention.

Fuel cell stack 802, which is composed of stacked fuel cells 801, is connected to inverter 803 and is connected to an external load.

Each fuel cell 801 is equipped with an automatic connection device 44, and connection device control line 45, voltage measurement line 46, and current line 47 are connected via the terminals of automatic connection device 44.

Next, the operation of the fuel cell power generation system of the present embodiment will be explained.

The terminal of automatic connection device 44 is opened during normal operation, and address signals from connection device control block 804 are received via connection device control line 45. Only if the address signal matches the address of automatic connection device 44 are voltage measurement line 46 and current line 47 connected, via automatic connection device 44, to fuel cell 801.

In this manner, it is possible to easily connect only a single cell to impedance measurement block 806, by means of a simple wiring configuration that utilizes a single voltage measurement line 46 an a single current line 47.

For a fuel cell 801 connected to impedance measurement block 806, a minute current is sampled by electronic load block 807, and the AC signal for a specific frequency is superimposed on the current by AC signal generation block 808.

Voltage measurement block 809 monitors a fuel cell 801 during load current variation. Impedance measurement block 806 computes the impedance from its voltage response, and fuel cell control block 805 controls to vary the operating conditions of fuel cell 801, in accordance with the impedance.

The impedance of each cell during normal operation is measured in advance, and both the address of the automatic connection device housed in each cell and the equivalent circuit component values discussed hereinafter are stored in advance.

By measuring the impedance as needed during operation and then determining the equivalent circuit component value and comparing it with the normal value, it is possible to determine the cell state in real time and to control optimally during an abnormality.

That is, the fuel cell system of the present embodiment determines the cause of an abnormality and responds appropriately to the cause of the abnormality, by using automatic connection device 44 housed in each cell to send specific address control signals to each cell, to connect only the target cell with the matching address to impedance measurement block 806.

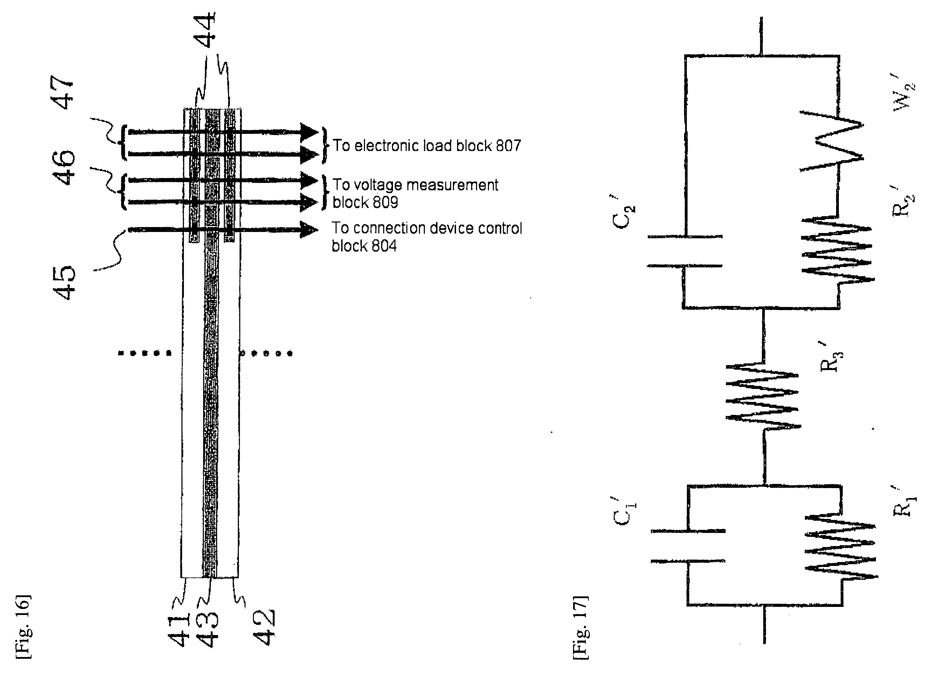

Next, the connection between impedance measurement block 806 and automatic connection device 44 housed in the separator will be discussed with reference to Fig. 16, the block diagram of the cell-housed automatic connection device 44 of the Embodiment 4 of the present invention.

Automatic connection device 44 has a different address for each cell. It receives specific signals from connection device control block 804, and only if the address and specific signal match is a connection made with impedance measurement block 806, electronic load block 807, AC signal generation block 808 or voltage measurement block 809.

Of course, if the address and specific signal do not match, automatic connection device 44 disconnects from impedance measurement block 806, electronic load block 807, AC signal generation block 808 or voltage measurement block 809.

Thus, only the target cell can be connected with impedance measurement block 806, electronic load block 807, AC signal generation block 808 or voltage measurement block 809.

Furthermore, the means including electronic load block 807 and AC signal generation block 808 corresponds to the load current variation means of the present invention; voltage measurement block 809 corresponds to the measurement means of the present invention; impedance measurement block 806 corresponds to the computation means of the present invention; fuel cell control block 805 corresponds to the fuel cell control means of the present invention; and the fuel cell power generation system of the present embodiment corresponds to the fuel cell system of the present invention. Also, current line 47 corresponds to the first wiring of the present invention; voltage measurement line 46 corresponds to the second wiring of the present invention; automatic connection device 44 corresponds to the connection means of the present invention; and the means including connection device control block 804 and connection device control line 45 corresponds to the connection means control means of the present invention.

The configuration and operation of the fuel cell system of the present embodiment were explained as aforementioned. Next, the principles of impedance computation and operating condition control in this fuel cell system will be explained next.

First, the equivalent circuit that represents cell impedance will be explained with reference to Fig. 17, the diagram of the equivalent circuit representing the cell impedance of Embodiment 4 of the present invention.

The impedance of a cell is composed of the anode impedance, the cathode impedance, and the electrolyte membrane impedance and contact resistance.

The behavior of this impedance can be represented by the equivalent circuit shown in Fig. 17.

By retrieving AC current (with frequency f and a small amplitude of at most 10% of the DC current retrieved from the fuel cell) after superimposing it on the DC current, it is possible to compute the complex impedance Z', as in aforementioned Embodiment 1.

Frequency f' of the AC current to be retrieved is swept from about 0.1 Hz to about 1000 Hz, and the complex impedance Z' at each frequency is computed.

Furthermore, it is preferable to measure the impedance while varying multiple specific frequencies and to measure the impedance by using an alternating current in which multiple specific frequencies are admixed.

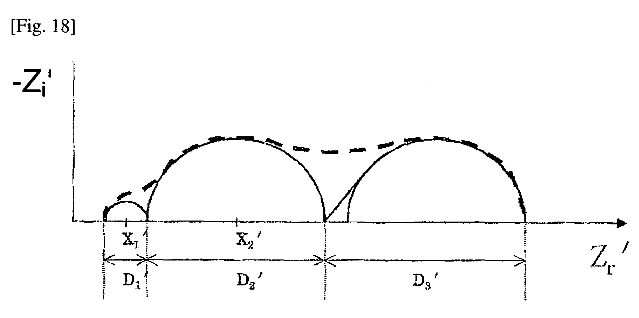

Then a Cole-Cole plot like that in Fig. 18, a diagram of the Cole-Cole plot of Embodiment 4 of the present invention, is prepared by plotting in a complex plane with $Z_r'$, its real part, as the horizontal axis, and with $-Z_i'$, the negative imaginary part $Z_i'$, as the vertical axis.

In Fig. 17, the Cole-Cole plot for the equivalent circuit having set $(R_1', C_1')$ containing a resistor (resistance) and capacitor (capacitance), set $(R_2', C_2', W_2')$ containing a resistor (resistance), capacitor (capacitance), and Warburg resistor (Warburg resistance), and resistor (resistance) $R_3'$ becomes the shape formed by superimposing and combining the curve connecting the circular arc and straight line and the two semicircles (i.e., the curve corresponding to the Cole-Cole plot for a Warburg resistor).

In Fig. 18, the curve connecting the circular arc and straight line and the two semicircles is represented by a solid line, and the shape formed by superimposing and combining these is represented by a broken line.

To conform to the drawn shape, the center coordinates and radii of the circular arcs are determined one by one, from the low-frequency side. For the first and second semicircles, the center coordinate is set to $X_1'$ and $X_2'$, respectively, and the diameter is set to $D_1'$ and $D_2'$, respectively. For the curve connecting the circular arc and straight line, the width is set to $D_3'$.

Then, letting the frequencies corresponding to the imaginary part's highest points on the circular arc connecting the straight line and the first and second semicircles be $f_1'$, $f_2'$, and $f_3'$, respectively,

[Relationships 34]

$$C_1' = \frac{1}{2\pi f_1' R_1'} = \frac{1}{2\pi f_1' D_1'} \ , \ C_2' = \frac{1}{2\pi f_2' R_2'} = \frac{1}{2\pi f_2' D_2'} \ ,$$

$$R_1' = D_1', \ R_2' = D_2', \ R_3' = X_1' - D_1'/'2,$$

$$W_2' = W_{2R}' \ \frac{\tanh\sqrt{2\pi f_3' \ jW_{2T}'}}{\sqrt{2\pi f_3' \ jW_{2T}'}} = D_3' \ \frac{\tanh\sqrt{2\pi f_3' \ jW_{2T}'}}{\sqrt{2\pi f_3' \ jW_{2T}'}} \ , \ W_{2R}' = D_3'$$

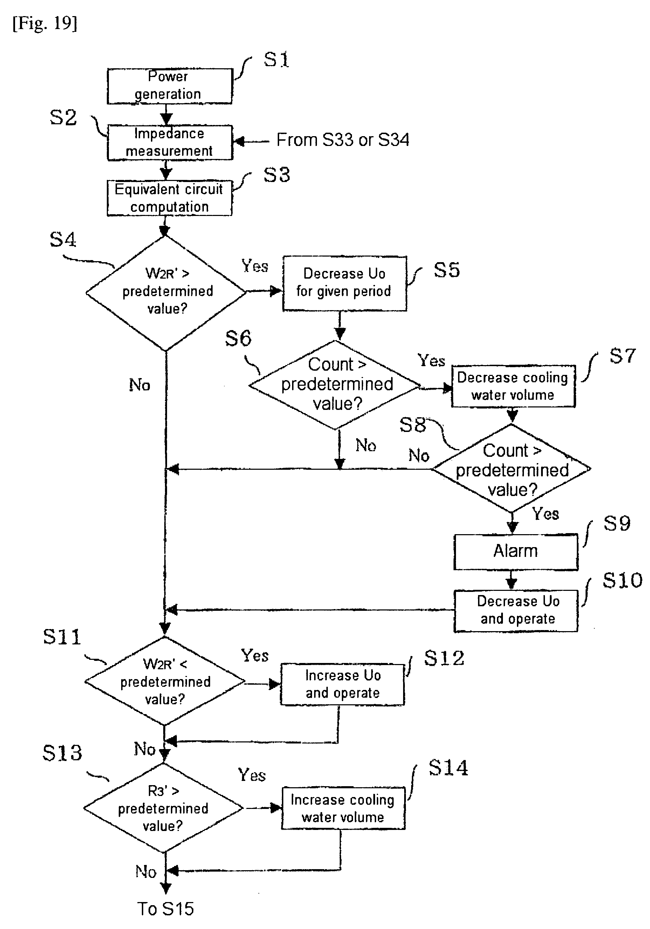

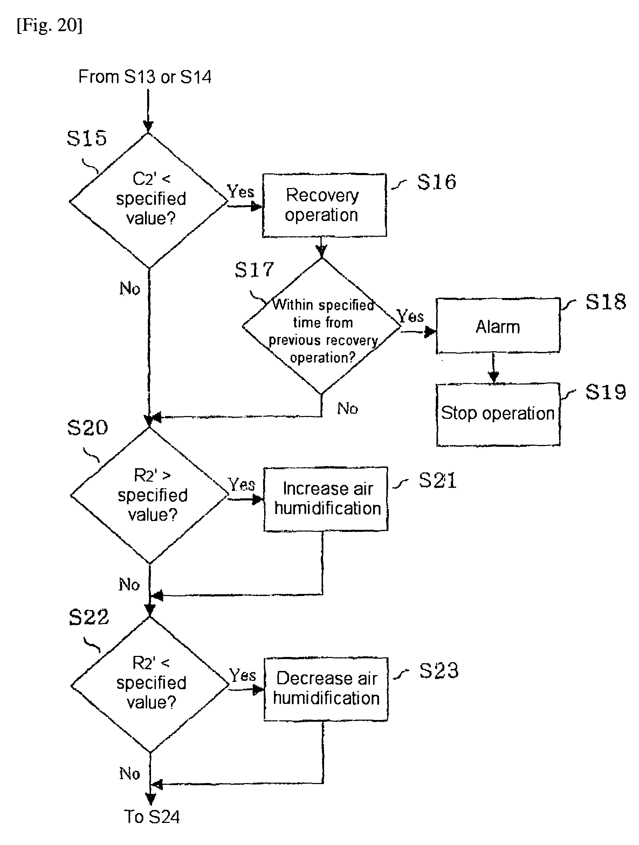

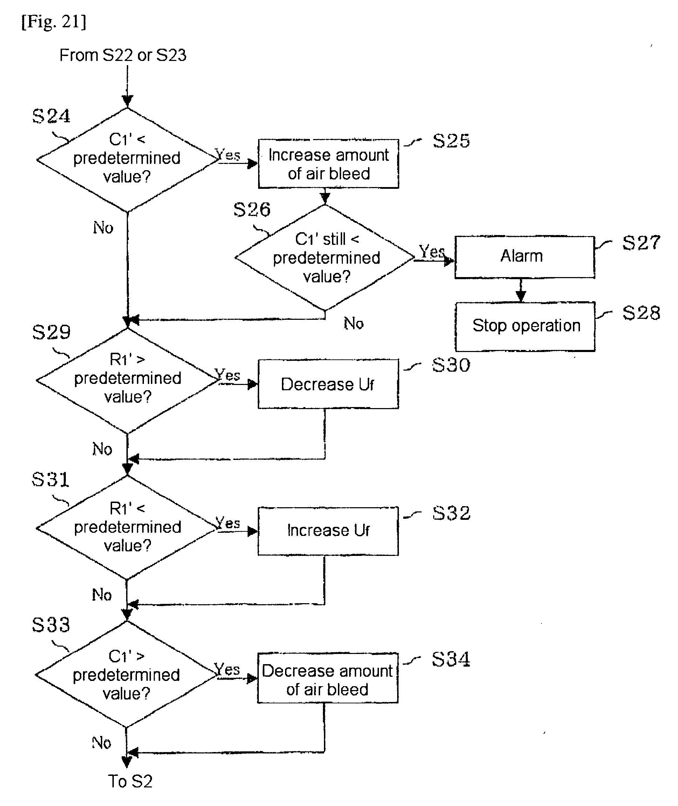

Furthermore, $W_{2T}'$ is the constant that becomes the gas diffusibility index.
In this manner, the value of each component of the equivalent circuit is computed, to conform to the drawn shape.
Then the cell operating conditions are varied to investigate the numeric variation of each component of the equivalent circuit.
When the dew point of the fuel gas is varied, mainly $C_1'$ and $R_1'$ vary. When the dew point of the gas containing oxygen is varied, mainly $C_2'$ and $R_2'$ vary. When the oxygen utilization rate of air, a gas containing oxygen, is varied, mainly $W_{2R}'$ varies. From this, it was determined that $C_1'$ corresponds to the electric double-layer capacity of the anode; $R_1'$ corresponds to the reaction resistance of the anode; $C_2'$ corresponds to the electric double-layer capacity of the cathode; $R_2'$ corresponds to the reaction resistance of the cathode; and $W_{2R}'$ corresponds to the diffusion resistance of the cathode.
Furthermore, because $R_3'$ decreases when the humidification is increased, it is known that $R_3'$ corresponds to the resistance of the polymer membrane.
Consequently, abnormality and deterioration of the reactive area of the anode catalyst layer can be detected and understood by investigating changes in $C_1'$.
Also, abnormality and deterioration of the reaction resistance of the anode catalyst layer can be detected and understood by investigating changes in $R_1'$.
Also, abnormality and deterioration of the reactive area of the cathode catalyst layer can be detected and understood by investigating changes in $C_2'$.
Also, abnormality and deterioration of the reaction resistance of the cathode catalyst layer can be detected and understood by investigating changes in $R_2'$.
Also, abnormality and deterioration of the diffusion resistance of the cathode gas diffusion layer can be detected and understood by investigating changes in $W_{2R}'$.
Also, abnormality and deterioration of the humidification state of the polymer membrane can be detected and understood by investigating changes in $R_3'$.
Next, this type of system control will be explained in further detail, with reference to Fig. 19, which is part 1 of the flowchart for explaining the system control of Embodiment 4 of the present invention, Fig. 20, which is part 2 of the flowchart for explaining the system control of Embodiment 4 of the present invention, and Fig. 21, which is part 3 of the flowchart for explaining the system control of Embodiment 4 of the present invention.
Steps 1-3: After power generation starts, the impedance is measured as needed.
Of course, fuel cells may be measured in address order or in random order.
The values of the components of the equivalent circuit are determined from the measured impedances.
Next, $W_2'$ of the equivalent circuit is determined.
Although $W_2'$ is the component based on the cathode gas diffusion, $W_{2R}'$ represents the magnitude of the diffusion resistance.
Steps 4-10: It can be concluded that, when $W_{2R}'$ increases, the gas diffusibility decreases as the result of the wetting progress. Therefore, when the value of $W_{2R}'$ exceeds the predetermined value, the air utilization rate $U_o'$ is decreased for a given amount of time, and the gas flow rate is increased, thereby eliminating the wetting. The number of iterations of the operation that decreases the air utilization rate $U_o'$ for a given amount of time is counted.
If this operation must be repeated numerous times and the count exceeds the predetermined value, the wetting is eliminated by increasing the cell temperature and decreasing the cooling water volume for a given amount of time.
The number of iterations of the operation that decreases the cooling water volume for a given amount of time is counted.
If this operation must be repeated numerous times and the count exceeds the predetermined value, it is inferred that the electrode material itself deteriorated, readily leading to wetting. An alarm is output, and operation continues in the state with a further reduced air utilization rate $U_o'$.
The alarm can be used to notify the user of the abnormality, to suggest maintenance, and to identify the cause of the problem during maintenance.

Steps 11-12: In the state where $W_{2R}'$ is below the predetermined value, it is inferred that drying progressed, so it is possible to prevent drying by increasing $U_o'$. (The gas flow rate also may be decreased.)

Next, $R_3'$ is determined.

$R_3'$ represents the magnitude of the resistance of the polymer membrane.

Steps 13-14: When $R_3'$ increases, it can be inferred the that polymer membrane resistance increased as the result of drying, so drying can be prevented by increasing the cooling water volume, thereby creating a state that facilitates wetting.

In Fig. 20, $R_2'$ and $C_2'$ are determined.

$R_2'$ represents the reaction resistance of the catalyst layer of the cathode, and $C_2'$ represents the reactive area of the catalyst layer of the cathode.

Steps 15-19: When $C_2'$ decreases, it is believed that the reactivity of the electrode catalyst decreased, so the apparent electrode surface area decreased. Therefore, when $C_2'$ is less than the predetermined value, the recovery operation is performed.

In the recovery operation, while fuel gas is flowed, the air is cut off, the load current is flowed, and instead of air, an inert gas is flowed, thereby lowering the cathodic potential (i.e., lowering the cell voltage).

This enables the restoration of an electrode catalyst with reactivity decreased by the adhesion of contaminants or the progress of oxidation.

However, if recovery fails to increase the reactive area or if the reactive area decreases shortly after the previous recovery operation, deterioration of the catalyst itself is considerable, so an alarm is output and operation is stopped.

Steps 20-21: When $R_2'$ increases, it can be inferred that the catalyst dried so the reactivity decreased. Therefore, when $R_2'$ exceeds the predetermined value, the air humidification is increased.

Steps 22-23: Conversely, when $R_2'$ decreases, catalyst wetting is excessive, so when $R_2'$ is less than the specified value, air humidification is decreased.

Next, Fig. 21 is used to determine $R_1'$ and $C_1'$. $R_1'$ represents the reaction resistance of the anode catalyst layer, and $C_1'$ represents the reactive area of the anode catalyst layer. Steps 24-28: When $C_1'$ decreases, it is believed that the anode catalyst was poisoned and the reactivity decreased, so the apparent electrode surface area decreased. So, the amount of air bleeding is increased when $C_1'$ is less than the predetermined value. Air bleeding adds a small amount of air to the fuel gas and, on the catalyst surface, oxidizes and eliminates the carbon monoxide that poisons the catalyst.

If $C_1'$ is less than the predetermined value even after the amount of air bleeding is increased, it implies considerable deterioration of the anode catalyst, so an alarm is output and operation is stopped.

Steps 29-30: When $R_1'$ increases, it can be inferred that the anode catalyst dried as the result of excessive fuel gas, so when $R_1'$ exceeds the predetermined value, the fuel utilization rate $U_f$ is decreased and operation is performed. (Furthermore, fuel gas humidification also may be increased.)

Steps 31-32: Conversely, when $R_1'$ decreases, excessive catalyst wetting can be inferred. So when $R_1'$ is less than the predetermined value, the fuel utilization rate $U_f$ is increased and operation is performed. (Furthermore, fuel gas humidification also may be decreased.)

Steps 33-34: When $C_1'$ increases, excessive air bleeding can be inferred. So when $C_1'$ exceeds the predetermined value, the amount of air bleeding is decreased.

Furthermore, the various predetermined values mentioned previously are set appropriately, within the range that allows the normal operating state to be maintained under system control.

After the operating state of the target cell has been determined in this manner, the address signal for the next target cell is sent from connection device control block 804. The same flow is used to measure and control the impedance of the target cell for which the address signal and the address of automatic connection device 44 agree. Thus, after one cell is measured, the address signal changes, thereby enabling the successive measurement of all fuel cells in fuel cell stack 802.

According to the present embodiment, by mean of a low-cost self-diagnostic function based on simple wiring, abnormal cells are determined easily and the cause of the abnormality can be identified, so it is possible to obtain a fuel cell system that enables highly reliable operation by means of the appropriate control.

Next, specific examples of the present invention will be explained.

Example 1

Production of the fuel cell power generation system in Example 1:

First, the gas diffusion layer was produced by means of the following method.

Then carbon paper (TGPH-060, made by Toray Industries, Inc.) was impregnated with 10 wt% (dry weight) polytetrafluoroethylene suspension (Lubron LDW-40, made by Daikin Industries, Ltd.), after which water-repelling treatment was performed using a hot-air dryer to heating at 350 °C.

Then a conductive layer containing a polymer composed of a fluoropolymer and carbon powder was formed.

That is, the suspension was produced by mixing 30 wt% (dry weight) polytetrafluoroethylene suspension (Lubron LDW-40, made by Daikin Industries, Ltd.) as the fluoropolymer, into Denka Black (made by Denki Kagaku Kogyo K.K.) as the carbon powder. The suspension produced in this manner was coated onto the carbon paper that was subjected to the water-repellent treatment mentioned previously, and a gas diffusion layer containing a conductive layer containing a polymer was produced by using a hot-air dryer to heat at 350 °C.

Next, the membrane-electrode assembly (MEA) was produced by means of the following method.

Catalyst paste was prepared by adding 10 g of water to 10 g of material (TEC10E50E, made by Tanaka Kikinzoku Kogyo K.K.) supporting 50-wt% platinum particles (average particle diameter: 30 Å) on electroconductive carbon powder, and by then admixing 55 g of 9-wt% ethanol solution of hydrogen ion-conductive polymer electrolyte (Flemion, made by Asahi Glass Co.).

The fuel electrode-side catalyst layer was formed by drying this paste after applying it to polypropylene film by means of bar-coating with a wire bar, thereby forming the oxidizing agent electrode-side catalyst layer and cathode-side catalyst layer, respectively. The amount of catalyst layer applied was controlled at a platinum content 0.3 mg per $cm^2$.

Catalyst paste was prepared by adding 10 g of water to 10 g of material (TEC61E54, made by Tanaka Kikinzoku Kogyo K.K.) supporting a platinum-ruthenium alloy on electroconductive carbon powder, and by then admixing 50 g of 9% ethanol solution of hydrogen ion-conductive polymer electrolyte membrane (Flemion, made by Asahi Glass Co.).

The fuel electrode-side catalyst layer was formed by drying this paste after applying it to polypropylene film by means of bar-coating with a wire bar, thereby forming the fuel electrode-side catalyst layer and anode-side catalyst layer, respectively. The amount of catalyst layer applied was controlled at a platinum content 0.3 mg per $cm^2$.

Polypropylene film with this catalyst layer was cut into 6-cm-square pieces, and the hydrogen ion-conductive polymer electrolyte membrane (GoreSelect, made by Japan Goretex, Inc.; membrane thickness: 30 μm) was interposed between two sheets of the aforementioned polypropylene film with a catalyst layer, with the catalyst layers inside. The polymer electrolyte membrane interposed between two sheets of polypropylene film in this manner was hot-pressed for 10 min. at 130 °C, after which the polypropylene film was eliminated, thereby yielding a polymer electrolyte membrane with catalyst layers.

An MEA was formed by interposing this polymer electrolyte membrane with catalyst layers between gas diffusion layers, with their polymer-containing electroconductive layers on the inside.

On the other hand, separator plates were formed by cutting a gas flow channel and a cooling water flow channel into graphite plates.

The MEA was interposed between a pair of separator plates, thereby forming a fuel cell.

This fuel cell was used to produce the fuel cell power generation system with the composition of Embodiment 1.

Start-up of operation of the fuel cell power generation system in Example 1:

On the fuel electrode side, the mixture formed by adding, as air bleed, air with 1 % the volume of the following mixed gas, to mixed gas (hydrogen: 80%; carbon dioxide: 20%; carbon monoxide: 20 ppm) that simulates reformed gas, was supplied after humidifying it to a dew point of 70 °C; and on the oxygen electrode side, air humidified to a dew point of 70 °C was supplied.

Power was generated at an 80% fuel utilization rate, a 40% oxygen utilization rate, and a 200-mA/$cm^2$ current density.

The cooling water was regulated to 70 °C on the inlet side and to 72-75 °C on the outlet side of fuel cell 501.

The voltage of fuel cell 501 was 0.75 V.

Control of operation of the fuel cell power generation system in Example 1:

AC signals (1 Hz, 2 Hz, 4 Hz, 8 Hz, 16 Hz, 32 Hz, 64 Hz, 128 Hz, 256 Hz) were generated by AC signal generator block 503, and the load current was controlled in sync with these signals. The load current was formed by superimposing the ±10-mA/$cm^2$ sine wave on the 200-mA/$cm^2$ direct current.

Voltage measurement block 504 monitored the voltage variation at this time; impedance measurement block 505 determined the impedance; and control was performed in accordance with the flow of Figs. 7-9.

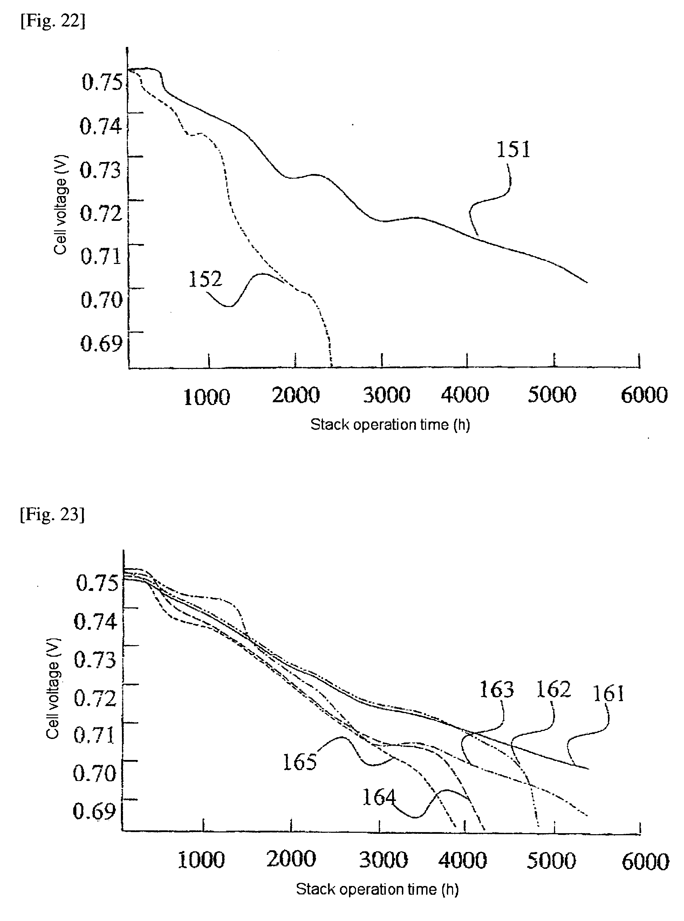

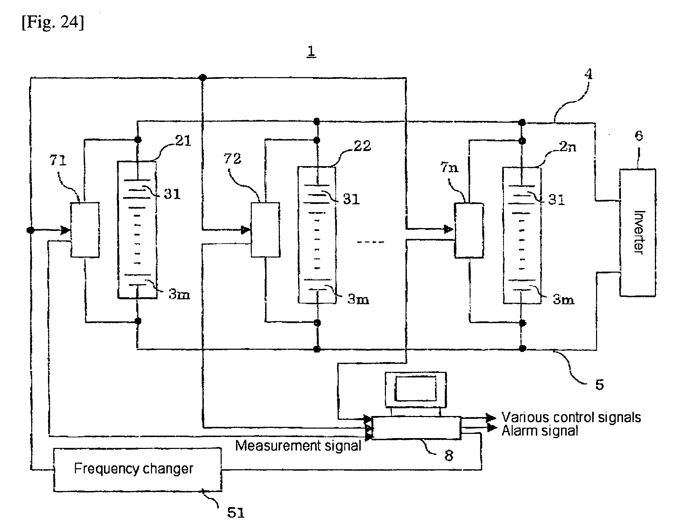

The variation over time in cell voltage is shown in Fig. 22, which shows the variation over time in cell voltage in the comparative example and Example 1 of the present invention, as cell voltage 151 of Example 1.

Even 5000 hours after the start of operation, cell voltage 151 was maintained at 0.70 V or higher.

Example 2

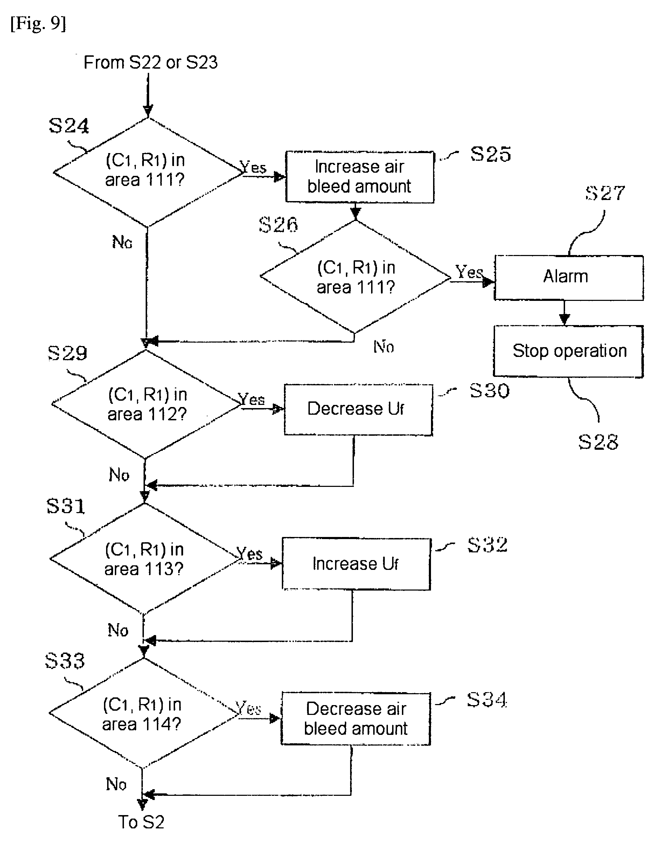

A fuel cell was formed as in Example 1, and this fuel cell was used to produce a fuel cell power generation system with the configuration of Embodiment 1, as in Example 1.
Operation was performed as in Example 1, and control was performed in accordance with the flow of Figs. 7-9.
In Example 2, however, the $U_f$ values of step 30 and step 32 in Fig. 9 were not increased or decreased.
The variation over time in cell voltage is shown in Fig. 23, which shows the variation over time in cell voltage in Examples 2-6 of the present invention, as cell voltage 161 of Example 2.
Even 5000 hours after the start of operation, cell voltage 161 was maintained at 0.70 V or higher.

Example 3

A fuel cell was formed as in Example 1, and this fuel cell was used to produce a fuel cell power generation system with the configuration of Embodiment 1, as in Example 1.
Operation was performed as in Example 1, and control was performed in accordance with the flow of Figs. 7-9.
In Example 3, however, the air bleed amounts of step 25 and step 34 in Fig. 9 were not increased or decreased.
The variation over time in cell voltage is shown in Fig. 23, as cell voltage 162 of Example 3.
Even 4500 hours after the start of operation, cell voltage 162 was maintained at 0.70 V or higher.

Example 4

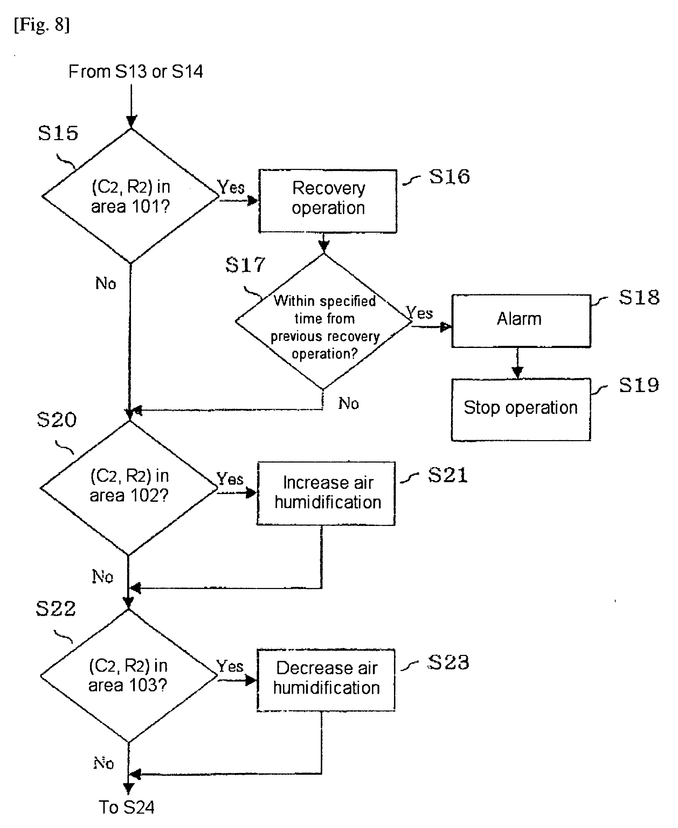

A fuel cell was formed as in Example 1, and this fuel cell was used to produce a fuel cell power generation system with the configuration of Embodiment 1, as in Example 1.
Operation was performed as in Example 1, and control was performed in accordance with the flow of Figs. 7-9.
In Example 4, however, the air humidification amounts of step 21 and step 23 in Fig. 8 were not increased or decreased.
The variation over time in cell voltage is shown in Fig. 23, as cell voltage 163 of Example 4.
Even 4000 hours after the start of operation, cell voltage 163 was maintained at 0.70 V or higher.

Example 5

A fuel cell was formed as in Example 1, and this fuel cell was used to produce a fuel cell power generation system with the configuration of Embodiment 1, as in Example 1.
Operation was performed as in Example 1, and control was performed in accordance with the flow of Figs. 7-9.
In Example 5, however, the cooling water volumes of step 12 and step 14 in Fig. 7 were not increased or decreased.
The variation over time in cell voltage is shown in Fig. 23, as cell voltage 164 of Example 5.
Even 3500 hours after the start of operation, cell voltage 164 was maintained at 0.70 V or higher.

Example 6

A fuel cell was formed as in Example 1, and this fuel cell was used to produce a fuel cell power generation system with the configuration of Embodiment 1, as in Example 1.
Operation was performed as in Example 1, and control was performed in accordance with the flow of Figs. 7-9.
In Example 6, however, the $U_o$ values of step 5, step 8, and step 10 in Fig. 7 were not increased or decreased.
The variation over time in cell voltage is shown in Fig. 23, as cell voltage 165 of Example 6.
Even 3000 hours after the start of operation, cell voltage 165 was maintained at 0.70 V or higher.

Example 7

Production of the fuel cell power generation system in Example 7:

A fuel cell was formed as in Example 1, and this fuel cell was used to produce a fuel cell power generation system with the configuration of Embodiment 2.

Start-up of operation of the fuel cell power generation system in Example 7:

On the fuel electrode side, power was generated at an 80% fuel utilization rate, a 40% oxygen utilization rate, and the 200-mA/cm$^2$ rated current density, by supplying, on the fuel electrode side, hydrogen gas humidified to a dew point of 70 °C; and by supplying, on the oxygen electrode side, air humidified to a dew point of 70 °C.
Power was generated at an 80% fuel utilization rate, a 40% oxygen utilization rate, and a 200-mA/cm$^2$ current density.
The cooling water was regulated to 70 °C on the inlet side and to 72-75 °C on the outlet side of fuel cell 601.

Control of operation of the fuel cell power generation system in Example 7:

Every day and night, the current density was decreased to 100 mA/cm$^2$ for 2 hours. Then, to cool fuel cell 601, the current density was set to zero and the system was stopped.
In the morning, after operating for 1 hour at a current density of 100 mA/cm$^2$, it was operated at the rated current density.
To increase or decrease the current density, a control signal was sent from load control block 603, and the load current of load 602 was increased or decreased stepwise. Voltage measurement block 604 monitored the voltage variation when the load increased or decreased, and these were digitized and subjected to Fourier transforms by Fourier transform block 605.
Impedance measurement block 606 determined the impedance, and control was performed in accordance with the flow of Figs. 7-9.
As in Example 1, even 5000 hours after the start of operation, the cell voltage was maintained at 0.70 V or higher.

Example 8

Production of the fuel cell power generation system in Example 8:

A fuel cell was formed as in Example 1, and 60 such fuel cells were stacked to form a fuel cell stack.
This was used to produce a fuel cell power generation system with the configuration of Embodiment 3.

Start-up of operation of the fuel cell power generation system in Example 8:

A lead wire was pulled from the separator plate of each fuel cell 701 and connected to voltage measurement block 705.
Power was generated at an 80% fuel utilization rate, a 40% oxygen utilization rate, and the 200-mA/cm$^2$ rated current density, by supplying, on the fuel electrode side, hydrogen gas humidified to a dew point of 70 °C, and by supplying, on the oxygen electrode side, air humidified to a dew point of 70 °C.
The cooling water was regulated to 70 °C on the inlet side and to 72-75 °C on the outlet side of fuel cell stack 702.

Control of operation of the fuel cell power generation system in Example 8:

As in Example 7, operation was performed after increasing or decreasing the current density, the impedance at that time was measured, and control was performed in accordance with the flow of Figs. 7-9.
As in Example 1, even 5000 hours after the start of operation, the cell voltage was maintained at 0.70 V or higher.

Comparative Example

Production of fuel cell power generation system in the comparative example:

The fuel cell power generation system of the present comparative example was produced as a fuel cell power generation system with a configuration resembling that of Example 1.

Start-up of operation of the fuel cell power generation system in the comparative example:

As in Example 1, power was generated at an 80% fuel utilization rate, a 40% oxygen utilization rate, and a 200-mA/cm$^2$ current density, by supplying, on the fuel electrode side, hydrogen gas humidified to a dew point of 70 °C, and by supplying, on the oxygen electrode side, air humidified to a dew point of 70 °C.

Control of operation of the fuel cell power generation system in the comparative example:

The fuel cell power generation system of the present comparative example was operated without varying the load current and without measuring the impedance.

The change over time in cell voltage is shown in Fig. 22 as cell voltage 152 of the comparative example.

Two thousand hours after the start of operation, cell voltage 152 fell below 0.70 V, and at 2500 hours thereafter, the power generation voltage fell precipitously, so power generation was stopped.

By comparing aforementioned Examples 1-8 and the comparative example, it is possible to determine the fuel cell state, according to the present invention. This enables the maintenance of the optimal fuel cell operating conditions, so it becomes evident that it is possible to maintain stable fuel cell power generation for a long time.

Also, the program of the present invention is used to execute on a computer all or some of the steps of the fuel cell operation method of the present invention, and the program operates in cooperation with the computer.

Also, the recording medium of the present invention supports the program used to execute on a computer all or some of the operations of all or some of the steps of the aforementioned fuel cell operation method of the present invention, and the recording medium is readable by computer and the aforementioned read program executes the aforementioned operations in cooperation with the aforementioned computer.

Furthermore, the aforementioned "some of the steps" of the present invention means one or a few of these multiple steps.

Also, the aforementioned "operations...of the steps (or process, operation, action, etc.)" of the present invention means the operation of all or some of the aforementioned steps.

Also, one usage mode of the program of the present invention may be the mode in which the program is recorded on a computer-readable recording medium, and operation is in cooperation with the computer.

Also, one usage mode of the program of the present invention may be the mode in which the program is transmitted via a transmission medium, read by the computer, and operated in cooperation with the computer.

Also, the recording medium includes a ROM, etc., and the transmission medium includes such transmission media as the Internet as well as light, radio waves, sound waves, etc.

Also, the aforementioned computer of the present invention is not limited to simple hardware (e.g., the CPU), and it may include the firmware and the operating system as well as peripherals.

Furthermore, as explained previously, the configuration of the present invention may be implemented in software or it may be implemented in hardware.

[Industrial Applicability]

The fuel cell system, fuel cell operation method, program, and recording medium of the present invention are useful because they allow fuel cell power generation abnormalities to be handled with higher reliability, as appropriate to the cause.

[Explanation of the Symbols]

| | |
|---|---|
| 1 | Fuel cell power generation system |
| 21, 22,...2n | Stacks |
| 31, 32,...3m | Cells |
| 4, 5 | Wiring |
| 51 | Frequency changer |
| 6 | Inverter |
| 71, 72,...7n | Impedance measurement device |
| 8 | Computer |
| 41 | Cathode-side separator |
| 42 | Anode-side separator |
| 43 | MEA |
| 44 | Automatic connection device |
| 45 | Connection device control line |
| 46 | Voltage measurement line |
| 47 | Current line |
| 501 | Fuel cell |
| 502 | Load |
| 503 | AC signal generation block |

| 504 | Voltage measurement block |
|---|---|
| 505 | Impedance measurement block |
| 506 | Fuel cell control block |
| 601 | Fuel cell |
| 602 | Load |
| 603 | Load control block |
| 604 | Voltage measurement block |
| 605 | Fourier transform block |
| 606 | Impedance measurement block |
| 607 | Fuel cell control block |
| 701 | Fuel cell |
| 702 | Fuel cell stack |
| 703 | Load |
| 704 | Load control block |
| 705 | Voltage measurement block |
| 706 | Fourier transform block |
| 707 | Impedance measurement block |
| 708 | Fuel cell control block |
| 801 | Fuel cell |
| 802 | Fuel cell stack |
| 803 | Inverter |
| 804 | Connection device control block |
| 805 | Fuel cell control block |
| 806 | Impedance measurement block |
| 807 | Electronic load block |
| 808 | AC signal generation block |
| 809 | Voltage measurement block |
| 901 | $(C_3, R_3)$ initial value |
| 1001 | $(C_2, R_2)$ initial value |
| 1101 | $(C_1, R_1)$ initial value |
| 151 | Example 1 cell voltage |
| 152 | Comparative example cell voltage |
| 161 | Example 2 cell voltage |
| 162 | Example 3 cell voltage |
| 163 | Example 4 cell voltage |
| 164 | Example 5 cell voltage |
| 165 | Example 6 cell voltage |

**Claims**

1. A fuel cell system comprising
a load current variation means that varies the load current of a fuel cell that operates to generate power,
a measurement means that measures the voltage response to the variation in the aforementioned load current,
a computation means that computes the impedance of the aforementioned fuel cell, based on the results of the measurement of the aforementioned voltage response,
and a fuel cell control means that varies the operating conditions of the aforementioned fuel cell, by utilizing the results of the computation of the aforementioned impedance.

2. The fuel cell system described in Claim 1, such that,
when the cells of the aforementioned fuel cell are connected in series and are represented by an equivalent circuit having (1) a resistor with resistance $R_3$, (2) a capacitor with capacitance $C_1$ and resistor with resistance $R_1$, which are connected in parallel and are equivalent to the reactive impedance of the anode of the aforementioned cell, (3) a capacitor with capacitance $C_2$ and resistor with resistance $R_2$, which are connected in parallel and are equivalent to the reactive impedance of the cathode of the aforementioned cell, and (4) a capacitor with capacitance $C_3$ and resistor with resistance $R_3$, which are connected in parallel and are equivalent to the diffusion impedance of the cathode of the aforementioned cell,
the computation of the impedance of the aforementioned fuel cell is the computation of aforementioned capacitance

$C_1$, aforementioned resistance $R_1$, aforementioned capacitance $C_2$, aforementioned resistance $R_2$, aforementioned capacitance $C_3$, and aforementioned resistance $R_3$.

3. The fuel cell system described in Claim 2, such that, when the set $(C_1, R_1)$ of aforementioned capacitance $C_1$ and aforementioned resistance $R_1$ lies within the predetermined region within the region

$$[\text{Relationship 1}] \qquad C_1 \leq a_1^{(L)}R_1 + b_1^{(L)}$$

defined by constant $a_1^{(L)}$ and constant $b_1^{(L)}$, in the coordinate plane with aforementioned capacitance $C_1$ as the horizontal axis and aforementioned resistance $R_1$ as the vertical axis, the operating conditions of the aforementioned fuel cell are varied to increase the amount of air bleeding for the predetermined fuel gas supplied to the aforementioned fuel cell.

4. The fuel cell system described in Claim 3, such that, even if the aforementioned amount of air bleeding is increased, if the aforementioned set $(C_1, R_1)$ lies within the aforementioned predetermined region, the predetermined warning is issued to the exterior, and the operation of the aforementioned fuel cell is stopped.

5. The fuel cell system described in Claim 2, such that, when the set $(C_1, R_1)$ of aforementioned capacitance $C_1$ and aforementioned resistance $R_1$ lies within the predetermined region within the region

$$[\text{Relationship 2}] \qquad a_1^{(U)}R_1 + b_1^{(U)} \leq C_1$$

defined by constant $a_1^{(U)}$ and constant $b_1^{(U)}$, in the coordinate plane with aforementioned capacitance $C_1$ as the horizontal axis and aforementioned resistance $R_1$ as the vertical axis, the operating conditions of the aforementioned fuel cell are varied to decrease the amount of air bleeding for the predetermined fuel gas supplied to the aforementioned fuel cell.

6. The fuel cell system described in Claim 2, such that, when the set $(C_1, R_1)$ of aforementioned capacitance $C_1$ and aforementioned resistance $R_1$ lies within the predetermined region within the region

$$[\text{Relationship 3}]\ R_1 \leq c_1^{(L)}C_1 + d_1^{(L)}$$

defined by constant $c_1^{(L)}$ and constant $d_1^{(L)}$, in the coordinate plane with aforementioned capacitance $C_1$ as the horizontal axis and aforementioned resistance $R_1$ as the vertical axis, the operating conditions of the aforementioned fuel cell are varied to increase the fuel gas utilization rate of the predetermined fuel gas supplied to the aforementioned fuel cell.

7. The fuel cell system described in Claim 6, such that the aforementioned predetermined region is the following region defined by constant $a_1^{(L)}$, constant $b_1^{(L)}$, constant $a_1^{(U)}$, and constant $b_1^{(U)}$, in addition to aforementioned constant $c_1^{(L)}$ and aforementioned constant $d_1^{(L)}$:

[Relationships 4]

$$\left\{ \begin{array}{l} R_1 \leq c_1^{(L)}C_1 + d_1^{(L)} \\ a_1^{(L)}R_1 + b_1^{(L)} \leq C_1 \leq a_1^{(U)}R_1 + b_1^{(U)} \end{array} \right.$$

8. The fuel cell system described in Claim 2, such that, when the set $(C_1, R_1)$ of aforementioned capacitance $C_1$ and aforementioned resistance $R_1$ lies within the predetermined region within the region

$$[\text{Relationship 5}] \qquad c_1^{(U)}C_1 + d_1^{(U)} \leq R_1$$

defined by constant $c_1^{(U)}$ and constant $d_1^{(U)}$, in the coordinate plane with aforementioned capacitance $C_1$ as the horizontal axis and aforementioned resistance $R_1$ as the vertical axis, the operating conditions of the aforementioned fuel cell are varied to decrease the fuel gas utilization rate of the predetermined fuel gas supplied to the aforementioned fuel cell.

**9.** The fuel cell system described in Claim 8, such that the aforementioned predetermined region is the following region defined by constant $a_1^{(L)}$, constant $b_1^{(L)}$, constant $a_1^{(U)}$, and constant $b_1^{(U)}$, in addition to aforementioned constant $c_1^{(U)}$ and aforementioned constant $d_1^{(U)}$:

[Relationships 6]

$$\left\{ \begin{array}{l} c_1^{(U)}C_1 + d_1^{(U)} \leq R_1 \\ a_1^{(L)}R_1 + b_1^{(L)} \leq C_1 \leq a_1^{(U)}R_1 + b_1^{(U)} \end{array} \right.$$

**10.** The fuel cell system described in Claim 2, such that, when the set $(C_2, R_2)$ of aforementioned capacitance $C_2$ and aforementioned resistance $R_2$ lies within the predetermined region within the region

[Relationship 7]     $C_2 \leq a_2^{(L)}R_2 + b_2^{(L)}$

defined by constant $a_2^{(L)}$ and constant $b_2^{(L)}$, in the coordinate plane with aforementioned capacitance $C_2$ as the horizontal axis and aforementioned resistance $R_2$ as the vertical axis, the operating conditions of the aforementioned fuel cell are varied to perform the predetermined recovery of the cathode catalyst in the aforementioned fuel cell.

**11.** The fuel cell system described in Claim 10, such that, even after the predetermined time elapsed after the aforementioned predetermined recovery was performed, if aforementioned set $(C_2, R_2)$ lies within the aforementioned predetermined region, the predetermined warning is issued to the exterior, and the operation of the aforementioned fuel cell is stopped.

**12.** The fuel cell system described in Claim 2, such that, when the set $(C_2, R_2)$ of aforementioned capacitance $C_2$ and aforementioned resistance $R_2$ lies within the predetermined region within the region

[Relationship 8]     $R_2 \leq c_2^{(L)}C_2 + d_2^{(L)}$

defined by constant $c_2^{(L)}$ and constant $d_2^{(L)}$, in the coordinate plane with aforementioned capacitance $C_2$ as the horizontal axis and aforementioned resistance $R_2$ as the vertical axis, the operating conditions of the aforementioned fuel cell are varied to decrease the humidification of the predetermined oxidant gas supplied to the aforementioned fuel cell.

**13.** The fuel cell system described in Claim 12, such that the aforementioned predetermined region is the ollowing] region defined by constant $a_2^{(L)}$ and constant $b_2^{(L)}$, in addition to aforementioned constant $c_2^{(L)}$ and aforementioned constant $d_2^{(L)}$:

[Relationships 9]

$$\left\{ \begin{array}{l} R_2 \leq c_2^{(L)}C_2 + d_2^{(L)} \\ a_2^{(L)}R_2 + b_2^{(L)} \leq C_2 \end{array} \right.$$

**14.** The fuel cell system described in Claim 2, such that, when the set $(C_2, R_2)$ of aforementioned capacitance $C_2$ and aforementioned resistance $R_2$ lies within the predetermined region within the region

[Relationship 10]     $c_2^{(U)}C_2 + d_2^{(U)} \leq R_2$

defined by constant $c_2^{(U)}$ and constant $d_2^{(U)}$, in the coordinate plane with aforementioned capacitance $C_2$ as the horizontal axis and aforementioned resistance $R_2$ as the vertical axis, the operating conditions of the aforementioned fuel cell are varied to increase the humidification of the predetermined oxidant gas supplied to the aforementioned fuel cell.

**15.** The fuel cell system described in Claim 14, such that the aforementioned predetermined region is the following region defined by constant $a_2^{(L)}$ and constant $b_2^{(L)}$, in addition to aforementioned constant $c_2^{(U)}$ and aforementioned constant $d_2^{(U)}$:

[Relationships 11]

$$\begin{cases} c_2^{(U)}C_2 + d_2^{(U)} \leq R_2 \\ a_2^{(L)}R_2 + b_2^{(L)} \leq C_2 \end{cases}$$

**16.** The fuel cell system described in Claim 2, such that, when the set $(C_3, R_3)$ of aforementioned capacitance $C_3$ and aforementioned resistance $R_3$ lies within the predetermined region within the region

[Relationship 12]     $C_3 \leq a_3^{(L)}R_3 + b_3^{(L)}$

defined by constant $a_3^{(L)}$ and constant $b_3^{(L)}$, in the coordinate plane with aforementioned capacitance $C_3$ as the horizontal axis and aforementioned resistance $R_3$ as the vertical axis, the operating conditions of the aforementioned fuel cell are varied to decrease the volume of cooling water supplied to the aforementioned fuel cell.

**17.** The fuel cell system described in Claim 16, such that the aforementioned predetermined region is the following region defined by constant $c_3^{(L)}$, constant $d_3^{(L)}$, constant $c_3^{(U)}$, and constant $d_3^{(U)}$, in addition to aforementioned constant $a_3^{(L)}$ and aforementioned constant $b_3^{(L)}$:

[Relationships 13]

$$\begin{cases} C_3 \leq a_3^{(L)}R_3 + b_3^{(L)} \\ c_3^{(L)}C_3 + d_3^{(L)} \leq R_3 \leq c_3^{(U)}C_3 + d_3^{(U)} \end{cases}$$

**18.** The fuel cell system described in Claim 2, such that, when the set $(C_3, R_3)$ of aforementioned capacitance $C_3$ and aforementioned resistance $R_3$ lies within the predetermined region within the region

[Relationship 14]     $a_3^{(U)}R_3 + b_3^{(U)} \leq C_3$

defined by constant $a_3^{(U)}$ and constant $b_3^{(U)}$, in the coordinate plane with aforementioned capacitance $C_3$ as the horizontal axis and aforementioned resistance $R_3$ as the vertical axis, the operating conditions of the aforementioned fuel cell are varied to increase the volume of cooling water supplied to the aforementioned fuel cell.

**19.** The fuel cell system described in Claim 18, such that the aforementioned predetermined region is the following region defined by constant $c_3^{(L)}$, constant $d_3^{(L)}$, constant $c_3^{(U)}$, and constant $d_3^{(U)}$, in addition to aforementioned constant $a_3^{(U)}$ and aforementioned constant $b_3^{(U)}$:

[Relationships 15]

$$\begin{cases} a_3^{(U)}R_3 + b_3^{(U)} \leq C_3 \\ c_3^{(L)}C_3 + d_3^{(L)} \leq R_3 \leq c_3^{(U)}C_3 + d_3^{(U)} \end{cases}$$

20. The fuel cell system described in Claim 2, such that, when the set $(C_3, R_3)$ of aforementioned capacitance $C_3$ and aforementioned resistance $R_3$ lies within the predetermined region within the region

[Relationship 16]    $R_3 \leq c_3^{(L)}C_3 + d_3^{(L)}$

defined by constant $c_3^{(L)}$ and constant $d_3^{(L)}$, in the coordinate plane with aforementioned capacitance $C_3$ as the horizontal axis and aforementioned resistance $R_3$ as the vertical axis, the operating conditions of the aforementioned fuel cell are varied to increase the oxidant gas utilization rate of the predetermined oxidant gas supplied to the aforementioned fuel cell.

21. The fuel cell system described in Claim 2, such that, when the set $(C_3, R_3)$ of aforementioned capacitance $C_3$ and aforementioned resistance $R_3$ lies within the predetermined region within the region

[Relationship 17]    $c_3^{(U)}C_3 + d_3^{(U)} \leq R_3$

defined by constant $c_3^{(U)}$ and constant $d_3^{(U)}$, in the coordinate plane with aforementioned capacitance $C_3$ as the horizontal axis and aforementioned resistance $R_3$ as the vertical axis, the operating conditions of the aforementioned fuel cell are varied to decrease the oxidant gas utilization rate of the predetermined oxidant gas supplied to the aforementioned fuel cell.

22. The fuel cell system described in Claim 21, such that, when the aforementioned oxidant gas utilization rate is less than the specified rate, the predetermined warning is issued to the exterior, and the aforementioned fuel cell continues to operate while the aforementioned oxidant gas utilization rate remains below the specified rate.

23. The fuel cell system described in Claim 1, such that,
when the cells of the aforementioned fuel cell are connected in series and are represented by an equivalent circuit having (1) a capacitor with capacitance $C_1'$, that is equivalent to the electric double-layer capacity of the anode, and a resistor with resistance $R_1'$, that is equivalent to the reaction resistance of the anode, both of which are connected in parallel, (2) a capacitor (2a) with capacitance $C_2'$, that is equivalent to the electric double-layer capacity of the cathode, and that is connected in parallel with (2b) a serially connected resistor with resistance $R_2'$, that is equivalent to the reaction resistance of the cathode, and a Warburg resistor with resistance $W_{2R}'$, that is equivalent to the diffusion resistance of the cathode, and (3) a resistor with resistance $R_3'$, that is equivalent to the resistance of the polymer membrane,
the computation of the impedance of the aforementioned fuel cell is the computation of aforementioned capacitance $C_1'$, aforementioned resistance $R_1'$, aforementioned capacitance $C_2'$, aforementioned resistance $R_2'$, aforementioned resistance $W_{2R}'$, and aforementioned resistance $R_3'$.

24. The fuel cell system described in Claim 23, such that, when aforementioned capacitance $C_1'$ is less than the predetermined minimum capacitance, the operating conditions of the aforementioned fuel cell are varied to increase the amount of air bleeding for the predetermined fuel gas supplied to the aforementioned fuel cell.

25. The fuel cell system described in Claim 24, such that, if the aforementioned capacitance $C_1'$ is less than the aforementioned predetermined minimum capacitance even after the aforementioned amount of air bleeding is increased, the predetermined warning is issued to the exterior, and the operation of the aforementioned fuel cell is stopped.

26. The fuel cell system described in Claim 23, such that, when aforementioned capacitance $C_1'$ exceeds the predetermined maximum capacitance, the operating conditions of the aforementioned fuel cell are varied to decrease the amount of air bleeding for the predetermined fuel gas supplied to the aforementioned fuel cell.

27. The fuel cell system described in Claim 23, such that, when aforementioned resistance $R_1'$ is less than the predetermined minimum resistance, the operating conditions of the aforementioned fuel cell are varied to increase the fuel gas utilization rate of the predetermined fuel gas supplied to the aforementioned fuel cell.

28. The fuel cell system described in Claim 23, such that, when aforementioned resistance $R_1'$ exceeds the predetermined maximum resistance, the operating conditions of the aforementioned fuel cell are varied to decrease the fuel gas utilization rate of the predetermined fuel gas supplied to the aforementioned fuel cell.

29. The fuel cell system described in Claim 23, such that, when aforementioned capacitance $C_2'$ is less than the predetermined minimum capacitance, the operating conditions of the aforementioned fuel cell are varied to perform the predetermined recovery of the cathode catalyst in the aforementioned fuel cell.

30. The fuel cell system described in Claim 29, such that, if the aforementioned capacitance $C_2'$ is less than the aforementioned predetermined minimum capacitance even after the specified time elapsed after the aforementioned predetermined recovery was performed, the predetermined warning is issued to the exterior, and the operation of the aforementioned fuel cell is stopped.

31. The fuel cell system described in Claim 23, such that, when aforementioned resistance $R_2'$ is less than the predetermined minimum resistance, the operating conditions of the aforementioned fuel cell are varied to decrease the humidification of the predetermined oxidant gas supplied to the aforementioned fuel cell.

32. The fuel cell system described in Claim 23, such that, when aforementioned resistance $R_2'$ exceeds the predetermined maximum resistance, the operating conditions of the aforementioned fuel cell are varied to increase the humidification of the predetermined oxidant gas supplied to the aforementioned fuel cell.

33. The fuel cell system described in Claim 23, such that, when aforementioned resistance $W_{2R}'$ is less than the predetermined minimum resistance, the operating conditions of the aforementioned fuel cell are varied to increase the oxidant gas utilization rate of the predetermined oxidant gas supplied to the aforementioned fuel cell.

34. The fuel cell system described in Claim 23, such that, when aforementioned resistance $W_{2R}'$ exceeds the predetermined maximum resistance, the operating conditions of the aforementioned fuel cell are varied to decrease the oxidant gas utilization rate of the predetermined oxidant gas supplied to the aforementioned fuel cell.

35. The fuel cell system described in Claim 34, such that, when aforementioned oxidant gas utilization rate is less than the specified rate, the operating conditions are varied to decrease the volume of cooling water supplied to the aforementioned fuel cell.

36. The fuel cell system described in Claim 35, such that, when the volume of cooling water supplied to the aforementioned fuel cell is less than the specified volume, the predetermined warning is issued to the exterior, and the aforementioned fuel cell continues to operate after the aforementioned oxidant gas utilization rate has been reduced further.

37. The fuel cell system described in Claim 23, such that, when aforementioned resistance $R_3'$ exceeds the predetermined maximum resistance, the operating conditions of the aforementioned fuel cell are varied to increase the volume of cooling water supplied to the aforementioned fuel cell.

38. The fuel cell system described in Claim 1, such that
the aforementioned load current is an AC current superimposed on the DC current output by the aforementioned fuel cell,
variation in the aforementioned load current is variation in the frequency of the aforementioned superimposed AC current,
and the aforementioned impedance is computed based on the results of the computation of the impedance of the aforementioned fuel cell, at the multiple frequencies of the aforementioned AC current whose frequency is varied.

39. The fuel cell system described in Claim 1, such that variation in the aforementioned load current is a stepwise variation of the aforementioned load current value, and the aforementioned impedance is computed based on both the frequency function obtained by subjecting to Fourier transformation the time function for the load current whose aforementioned current is varied stepwise and the frequency function obtained by subjecting to Fourier transformation the time function of the voltage response to the variation of the aforementioned load current.

**40.** The fuel cell system described in Claim 1, such that

the aforementioned fuel cell has multiple cells,

for the aforementioned measurement means, the aforementioned voltage response is measured for each of the aforementioned cells,

for the aforementioned computation means, the impedance of the aforementioned fuel cell is computed for each of the aforementioned cells,

and for the aforementioned fuel cell control means, the operating conditions of the aforementioned fuel cell are varied for each of the aforementioned cells.

**41.** The fuel cell system described in Claim 40, that is equipped additionally with first wiring for electrically connecting the aforementioned multiple cells to the aforementioned load current variation means,

second wiring for electrically connecting the aforementioned multiple cells to the aforementioned measurement means,

multiple connection means provided for each of the aforementioned cells, for making/breaking the electrical connection between the aforementioned multiple cells and the aforementioned first wiring, and for making/breaking the electrical connection between the aforementioned multiple cells and the aforementioned second wiring,

and a connection means control means for controlling the aforementioned multiple connection means, by utilizing predetermined control signals.

**42.** The fuel cell system described in Claim 1, such that the aforementioned fuel cell is connected in series with the inverter for orthogonal transformation.

**43.** A fuel cell operation method provided with

a load current variation step that varies the load current of a fuel cell that operates to generate power,

a measurement step that measures the voltage response of the aforementioned load current variation,

a computation step that computes the impedance of the aforementioned fuel cell, based on the results of the measurement of the aforementioned voltage response,

and a fuel cell control step that varies the operating conditions of the aforementioned fuel cell, by utilizing the results of the computation of the aforementioned impedance.

**44.** A program for executing on a computer the following steps of the fuel cell operation method according to Claim 43:

a load current variation step that varies the load current of a fuel cell that operates to generate power,

a computation step that computes the impedance of the aforementioned fuel cell, based on the results of the measurement of the aforementioned voltage response,

and a fuel cell control step that varies the operating conditions of the aforementioned fuel cell, by utilizing the results of the computation of the aforementioned impedance.

**45.** A recording medium that supports the program of Claim 44 and that is a recording medium that is computer compatible.

[Fig. 1]

[Fig. 2]

[Fig. 3]

[Fig. 4]

[Fig. 5]

[Fig. 6]

[Fig. 7]

```
                        ┌──────────────┐
                        │  Generate    │──── S1
                        │   power      │
                        └──────┬───────┘
                               │
                        ┌──────▼───────┐
         S2  ──────────│   Measure    │◄────────
                        │  impedance   │
                        └──────┬───────┘
                               │
                        ┌──────▼──────────┐
                        │ Equivalent circuit│──── S3
                        │  computation    │
                        └──────┬──────────┘
                               │
      S4 ─────────            ◆                          ┌──────────────┐
                    ╱  (C3, R3) in  ╲  Yes               │ Decrease Uo for │──── S5
                    ╲    area 91?   ╱ ───────────────────│  given period   │
                     ◆                                   └──────┬──────────┘
                        │ No                                    │
                        │               S6 ◆               ┌────▼─────┐
                        │                ╱ Count exceeds ╲  Yes │  Alarm  │──── S7
                        │                ╲ predetermined ╱ ─────│         │
                        │                 ╲   value?    ╱       └────┬────┘
                        │                  ◆                         │
                        │                   │ No          ┌──────────▼──────┐
                        │                   │    No        │  Decrease Uo    │──── S8
                        │◄──────────────────┴──────────────│  and operate    │
                        │                                  └─────────────────┘
      S9 ─────────      ◆                          ┌──────────────┐
                    ╱  (C3, R3) in  ╲  Yes         │ Increase Uo   │──── S10
                    ╲    area 92?   ╱ ─────────────│ and operate   │
                     ◆                             └──────┬────────┘
                        │ No ◄─────────────────────────────┘
                        │
     S11 ─────────      ◆                          ┌──────────────┐
                    ╱  (C3, R3) in  ╲  Yes         │Decrease cooling│──── S12
                    ╲    area 93?   ╱ ─────────────│ water volume  │
                     ◆                             └──────┬────────┘
                        │ No ◄─────────────────────────────┘
                        │
     S13 ─────────      ◆                          ┌──────────────┐
                    ╱  (C3, R3) in  ╲  Yes         │Increase cooling│──── S14
                    ╲    area 94?   ╱ ─────────────│ water volume  │
                     ◆                             └──────┬────────┘
                        │ No ◄─────────────────────────────┘
                        │
                        ▼
                     To S15
```

[Fig. 8]

From S13 or S14

S15 — (C2, R2) in area 101? — Yes → Recovery operation — S16

No ↓

S17 — Within specified time from previous recovery operation? — Yes → Alarm — S18

↓ No

S18 Alarm → Stop operation — S19

S20 — (C2, R2) in area 102? — Yes → Increase air humidification — S21

No ↓

S22 — (C2, R2) in area 103? — Yes → Decrease air humidification — S23

No ↓

To S24

[Fig. 9]

From S22 or S23

S24 — (C1, R1) in area 111? — Yes → S25 Increase air bleed amount

No

S26 — (C1, R1) in area 111? — Yes → S27 Alarm → Stop operation — S28

No

S29 — (C1, R1) in area 112? — Yes → S30 Decrease Uf

No

S31 — (C1, R1) in area 113? — Yes → S32 Increase Uf

No

S33 — (C1, R1) in area 114? — Yes → S34 Decrease air bleed amount

No

To S2

[Fig. 10]

[Fig. 11]

[Fig. 12]

[Fig. 13]

[Fig. 14]

[Fig. 15]

[Fig. 16]

45 46 47

41
43
42

44

To connection device control block 804

To voltage measurement block 809

To electronic load block 807

[Fig. 17]

$C_1{}'$ $C_2{}'$

$R_3{}'$

$R_1{}'$ $R_2{}'$ $W_2{}'$

[Fig. 18]

$-Z_i'$

$X_1'$ $X_2'$

$D_1'$ $D_2'$ $D_3'$

$Z_r'$

[Fig. 19]

[Fig. 20]

From S13 or S14

S15
C2' < specified value?
Yes → Recovery operation — S16

S17
Within specified time from previous recovery operation?
Yes → Alarm — S18
→ Stop operation — S19
No

No

S20
R2' > specified value?
Yes → Increase air humidification — S21
No

S22
R2' < specified value?
Yes → Decrease air humidification — S23
No

To S24

[Fig. 21]

From S22 or S23

S24 — C1' < predetermined value?

Yes → Increase amount of air bleed — S25

No ↓

S26 — C1' still < predetermined value?

Yes → Alarm — S27 → Stop operation — S28

No ↓

S29 — R1' > predetermined value?

Yes → Decrease Uf — S30

No ↓

S31 — R1' < predetermined value?

Yes → Increase Uf — S32

No ↓

S33 — C1' > predetermined value?

Yes → Decrease amount of air bleed — S34

No ↓

To S2

[Fig. 22]

[Fig. 23]

[Fig. 24]